(19) Europäisches Patentamt
European Patent Office
Office européen des brevets

(11) EP 2 363 748 B1

(12) EUROPEAN PATENT SPECIFICATION

(45) Date of publication and mention of the grant of the patent:
**13.04.2016 Bulletin 2016/15**

(51) Int Cl.:
*G03F 7/027* (2006.01) *G03F 7/032* (2006.01)
*G03F 7/09* (2006.01) *G03F 7/30* (2006.01)
*B41C 1/10* (2006.01)

(21) Application number: **11154129.8**

(22) Date of filing: **11.02.2011**

(54) **Lithographic printing plate precursor and plate making method thereof**

Lithographiedruckplattenvorläufer und Plattenherstellungsverfahren dafür

Précurseur de plaque d'impression lithographique et procédé de fabrication de plaque correspondant

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.02.2010 JP 2010029447**

(43) Date of publication of application:
**07.09.2011 Bulletin 2011/36**

(73) Proprietor: **Fujifilm Corporation**
**Minato-ku**
**Tokyo (JP)**

(72) Inventors:
- **Shimono, Katsuhiro**
  **Shizuoka (JP)**
- **Oohashi, Hidekazu**
  **Shizuoka (JP)**

(74) Representative: **Hoffmann Eitle**
**Patent- und Rechtsanwälte PartmbB**
**Arabellastraße 30**
**81925 München (DE)**

(56) References cited:
**WO-A2-2007/077207**
**JP-A- 2009 226 730**
**US-A1- 2010 009 130**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 363 748 B1

## Description

FIELD OF THE INTENTION

The present invention relates to a lithographic printing plate precursor and a plate making method using the same. More particularly, it relates to a lithographic printing plate precursor capable of undergoing a direct plate making on a printing machine after image exposure with laser and a plate making method comprising on-press development of the lithographic printing plate precursor.

BACKGROUND OF THE INVENTION

In general, a lithographic printing plate is composed of an oleophilic image area accepting ink and a hydrophilic non-image area accepting dampening water (fountain solution) in the process of printing. Lithographic printing is a printing method utilizing the nature of water and oily ink to repel with each other and comprising rendering the oleophilic image area of the lithographic printing plate to an ink-receptive area and the hydrophilic non-image area thereof to a dampening water-receptive area (ink-unreceptive area), thereby making a difference in adherence of the ink on the surface of the lithographic printing plate, depositing the ink only to the image area, and then transferring the ink to a printing material, for example, paper.

In order to produce the lithographic printing plate, a lithographic printing plate precursor (PS plate) comprising a hydrophilic support having provided thereon an oleophilic photosensitive resin layer (image-recording layer) is used. Specifically, the PS plate is exposed through a mask, for example, a lith film, and then subjected to development processing, for example, with an alkaline developer to remove the unnecessary image-recording layer corresponding to the non-image area by dissolving while leaving the image-recording layer corresponding to the image area, thereby obtaining the lithographic printing plate.

Due to the recent progress in the technical field, nowadays the lithographic printing plate can be obtained by a CTP (computer-to-plate) technology. Specifically, a lithographic printing plate precursor is directly subjected to scanning exposure using laser or laser diode without using a lith film and developed to obtain a lithographic printing plate.

With the progress described above, the issue on the lithographic printing plate precursor has transferred to improvements, for example, in image-forming property corresponding to the CTP technology, printing property or physical property. Also, with the increasing concern about global environment, as another issue on the lithographic printing plate precursor, an environmental problem on waste liquid discharged accompanying the wet treatment, for example, development processing comes to the front.

In response to the environmental problem, simplification of development or plate making or non-processing has been pursued. As one method of simple plate making, a method referred to as an "on-press development" is practiced. Specifically, according to the method after exposure of a lithographic printing plate precursor, the lithographic printing plate precursor is mounted as it is on a printing machine without conducting conventional development and removal of the unnecessary area of image-recording layer is performed at an early stage of printing step.

Also, as a method of simple development, a method referred to as a "gum development" is practiced wherein the removal of the unnecessary area of image-recording layer is performed using not a conventional high alkaline developer but a finisher or gum solution of near-neutral pH.

In the simplification of plate making operation as described above, a system using a lithographic printing plate precursor capable of being handled in a bright room or under a yellow lump and a light source is preferable from the standpoint of workability. Thus, as the light source, a semiconductor laser emitting an infrared ray having a wavelength of 760 to 1,200 or a solid laser, for example, YAG laser, is used. An UV laser is also used.

As the lithographic printing plate precursor capable of undergoing on-press development, for instance, a lithographic printing plate precursor having provided on a hydrophilic support, an image-recording layer (thermosensitive layer) containing microcapsules having a polymerizable compound encapsulated therein is described in JP-A-2001-277740 (the term "JP-A" as used herein means an "unexamined published Japanese patent application") and JP-A-2001-277742. Also, a lithographic printing plate precursor having provided on a support, an image-recording layer (photosensitive layer) containing an infrared absorbing agent, a radical polymerization initiator and a polymerizable compound is described in JP-A-2002-287334. Further, a lithographic printing plate precursor capable of undergoing on-press development having provided on a support, an image-recording layer containing a polymerizable compound and a graft polymer having a polyethylene oxide chain in its side chain or a block polymer having a polyethylene oxide block is described in U.S. Patent Publication No. 2003/0064318.

It is described in JP-T-2009-522609 (the term "JP-T" as used herein means a published Japanese translation of a PCT patent application, WO 2007/077207 A2) that a lithographic printing plate precursor using a urethane oligomer as a radical polymerizable compound has good photosensitivity, high resolution and printing durability and does not generate sludge in a developer bath. Also, there is a description that the unexposed area of a photosensitive layer is

removed with printing ink and/or dampening water on a printing machine. However, in case of the lithographic printing plate precursor of on-press development type, even when the urethane oligomer described in the prior art is used, it is unable to fulfill sufficient printing durability and also to achieve the problems relating to sufficient on-press development property, stain resistance and on-press development scum.

Further, a non-processing lithographic printing plate precursor which does not need any development processing and comprises a hydrophilic layer containing a specific hydrophilic polymer and a microcapsule including a specific reactive urethane oligomer capable of being converted to the image area with heat on a support is described in JP-A-2001-1658. However, although such a non-processing lithographic printing plate precursor has an advantage of non-processing, printing durability and stain resistance are still insufficient from the practical standpoint.

In JP-A-2009-226730 another lithographic printing plate precursor for on-press development is disclosed, wherein the image-forming layer comprises polymer particles and may also comprise radical polymerizable urethane oligomers having a weight average molecular weight of about 70,000.

SUMMARY OF THE INVENTION

An object of the present invention is to provide a lithographic printing plate precursor of on-press development type which exhibits high printing durability, excellent stain resistance and less development scum and a plate making method thereof.

1. A lithographic printing plate precursor comprising: a support; and an image-recording layer an unexposed area of which is capable of being removed with dampening water and/or printing ink and contains (a) an infrared absorbing agent, (b) a radical polymerization initiator, (c) a polymer particle, and (d) a radical polymerizable urethane oligomer, wherein (d) the radical polymerizable urethane oligomer has a polymerizable group and at least one hydrophilic group selected from a sulfo group, a group having a polyoxyalkylene chain, a hydroxy group, an amido group, an ammonium group and a group having a betaine structure and a weight average molecular weight (Mw) from 1,500 to 10,000 and is present outside of (c) the polymer particle.
2. The lithographic printing plate precursor as described in the above item 1, wherein the hydrophilic group is any of a group having a polyoxyalkylene chain, an amido group and a group having a betaine structure.
3. The lithographic printing plate precursor as described in the above item 2, wherein the hydrophilic group is a group having a polyoxyethylene chain.
4. The lithographic printing plate precursor as described in the above item 3, wherein a number of oxyethylene repeating unit in the polyoxyethylene chain is from 2 to 20.
5. The lithographic printing plate precursor as described in any one of the above items 1 to 4, wherein a weight average molecular weight (Mw) of the radical polymerizable urethane oligomer is from 2,000 to 5,000.
6. The lithographic printing plate precursor as described in any one of the above items 1 to 5, wherein the radical polymerizable urethane oligomer is a radical polymerizable urethane oligomer obtained by reaction of at least (A) a trifunctional or more functional isocyanate compound, (B) a compound having a methacryloyl group or an acryloyl group and a hydroxy group and (C) a compound having a hydrophilic group and a hydroxy group, and at least any of (B) and (C) has two or more hydroxy groups.
7. The lithographic printing plate precursor as described in any one of the above items 1 to 6, wherein the polymer particle contains a polyoxyalkylene chain.
8. The lithographic printing plate precursor as described in the above item 7, wherein the polyoxyalkylene chain contained in the polymer particle is a polyoxyethylene chain.
9. The lithographic printing plate precursor as described in the above item 8, wherein a number of oxyethylene repeating unit in the polyoxyethylene chain contained in the polymer particle is from 2 to 20.
10. The lithographic printing plate precursor as described in any one of the above items 1 to 9, wherein the polymer particle is an organic resin particle having as a constituting component, at least acrylonitrile monomer unit.
11. The lithographic printing plate precursor as described in any one of the above items 1 to 10, wherein the polymer particle contains a monomer unit having one or more ethylenically unsaturated groups.
12. The lithographic printing plate precursor as described in any one of the above items 1 to 11, which comprises a protective layer on the image-recording layer.
13. The lithographic printing plate precursor as described in the above item 12, wherein the protective layer contains a hydrophilic resin.
14. The lithographic printing plate precursor as described in the above item 12 or 13, wherein the protective layer contains an inorganic stratifonn compound.
15. A plate making method of a lithographic printing plate comprising exposing imagewise the lithographic printing plate precursor as described in any one of the above items 1 to 14, and without undergoing a development processing step, supplying dampening water and/or printing ink to remove an unexposed area of the image-recording layer,

thereby preparing a lithographic printing plate.

According to the present invention, a lithographic printing plate precursor of on-press development type which exhibits high printing durability, excellent stain resistance and less development scum can be obtained.

## DERAILED DESCRIPTION OF THE INTENTION

[Lithographic printing plate precursor]

The lithographic printing plate precursor according to the invention comprises a support and an image-recording layer an unexposed area of which is capable of being removed with dampening water and/or printing ink and contains (a) an infrared absorbing agent, (b) a radical polymerization initiator, (c) a polymer particle, and (d) a radical polymerizable urethane oligomer, wherein (d) the radical polymerizable urethane oligomer has a polymerizable group and at least one hydrophilic group selected from a sulfo group, a group having a polyoxyalkylene chain, a hydroxy group, an amido group, an ammonium group and a group having a betaine structure and a weight average molecular weight (Mw) from 1,500 to 10,000 and is present outside of (c) the polymer particle.

The constituting element, component and the like of the lithographic printing plate precursor will be described in detail below.

(Image-recording layer)

(d) Radical polymerizable urethane oligomer

The radical polymerizable urethane oligomer according to the invention is characterized by having at least one polymerizable group and at least one hydrophilic group. It is preferable that the radical polymerizable urethane oligomer has at least two polymerizable groups. The hydrophilic group is at least one group selected from a sulfo group, a group having a polyoxyalkylene chain, a hydroxy group, an amido group, an ammonium group and a group having a betaine structure. The sulfo group may be a sulfonate group. Of the hydrophilic groups, a group having a polyoxyalkylene chain, an amido group and a group having a betaine structure are preferred.

The weight average molecular weight (Mw) of the radical polymerizable urethane oligomer according to the invention is from 1,500 to 10,000, preferably from 2,000 to 8,000, and most preferably from 2,000 to 5,000. The weight average molecular weight can be determined by dissolving the radical polymerizable urethane oligomer in a solvent, for example, dimethylacetamide (DMAc) and measuring by a gel permeation chromatography (GPC) device using polystyrene as a standard substance.

The radical polymerizable urethane oligomer according to the invention is preferably that dissolved in DMAc at concentration of 10% by weight or more at 25°C.

The radical polymerizable urethane oligomer according to the invention is characterized by being present outside of (c) the polymer particle in the image-recording layer.

The radical polymerizable urethane oligomer can be obtained by reacting (A) a trifunctional or more functional isocyanate compound, (B) a compound having a polymerizable group and a hydroxy group and (C) a compound having a hydrophilic group and a hydroxy group. However, at least one of (B) and (C) may have two or more hydroxy groups. The radical polymerizable urethane oligomer may also contain (D) other component as the fourth component other than (A) to (C).

<Trifunctional or more functional isocyanate compound [(A) component]>

As (A) component, any trifunctional or more functional isocyanate compound is suitably used and a triisocyanate compound and a tetraisocyanate compound are preferred. More preferable compounds are those represented by formula (I) or (II) shown below and these compounds may be used in mixture of two or more kinds.

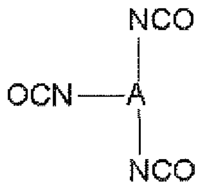

(I)

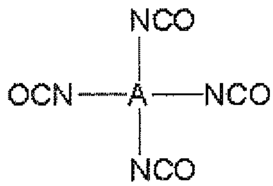

(II)

In Formulae (I) and (II), A represents a trivalent or tetravalent organic residue constituted of nonmetal atoms and includes those constituted of elements selected from 3 to 30 carbon atoms, up to 10 nitrogen atoms, up to 10 oxygen atoms, up to 10 halogen atoms, up to 10 silicon atoms, from 3 to 100 hydrogen atoms, up to 10 phosphorus atoms and up to 10 sulfur atoms. Among them, combinations of from 2 to 30 carbon atoms, up to 5 nitrogen atoms, up to 8 oxygen atoms and from 3 to 50 hydrogen atoms are preferred.

Trivalent or tetravalent organic residues composed of the atoms and structures in connecting groups shown below and combinations thereof are more preferred.

(Atoms and connecting groups)

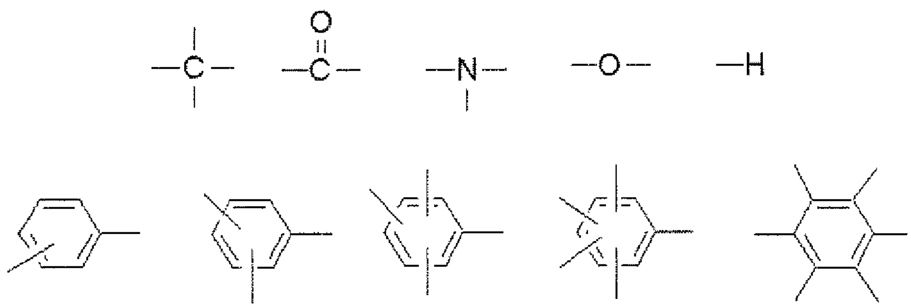

Specific examples of (A) component are set forth below, but the invention should not be construed as being limited thereto.

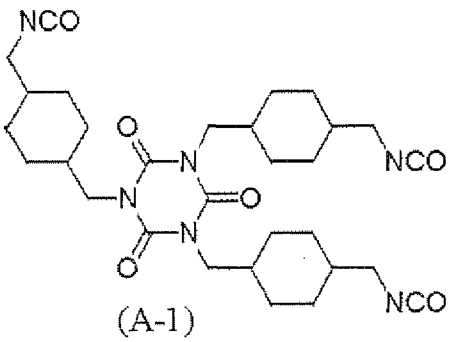

(A-1)

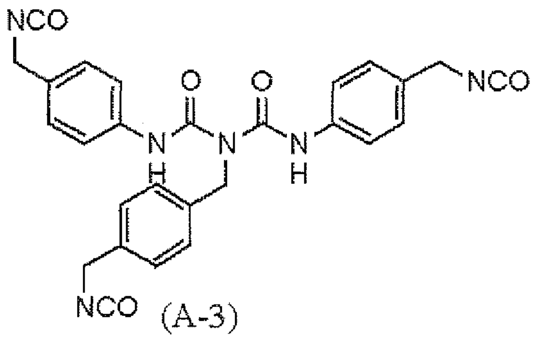

(A-3)

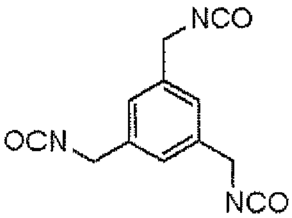

(A-2)

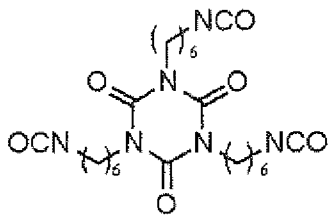

(A-4)

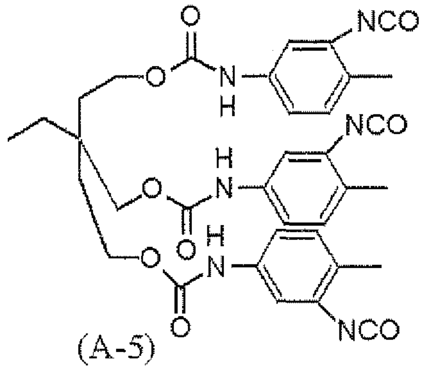

(A-5)

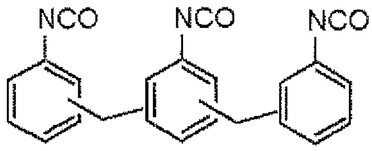

(A-6)

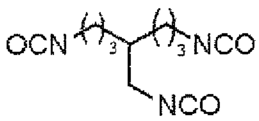

(A-7)

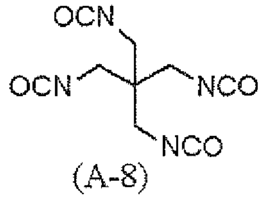

(A-8)

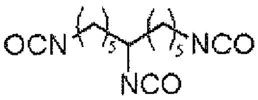

(A-9)

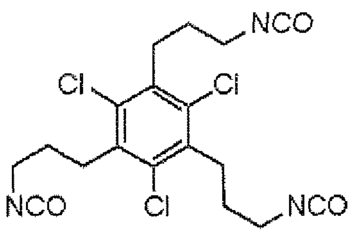

(A-10)

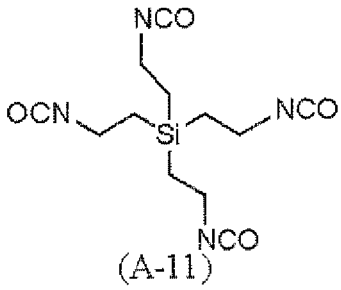

(A-11)

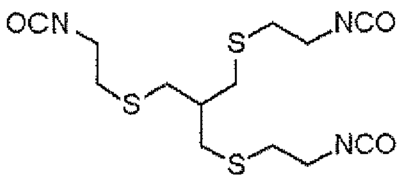

(A-12)

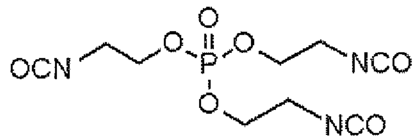

(A-13)

<(B) Compound having polymerizable group and hydroxy group [(B) Component]>

As (B) Component, any compound having a polymerizable group and a hydroxy group is suitably used and compounds having from 1 to 4 hydroxy groups are preferred, compounds having from 1 to 3 hydroxy groups are more preferred, and compounds having 1 or 2 hydroxy groups are particularly preferred.

The number of the polymerizable group is suitably one or more, preferably from 2 to 10, more preferably from 2 to 8, and most preferably from 3 to 6.

As the polymerizable group, an ethylenically unsaturated group is preferably used, and specifically a methacryl group, an acryl group, an allyl group, a styryl group and a vinyl group are preferred, and a methacryl group, an acryl group and a styryl group are more preferred.

Preferred (B) components include compounds represented by formulae (III) to (V) shown below.

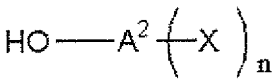

(III)

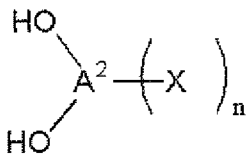

(IV)

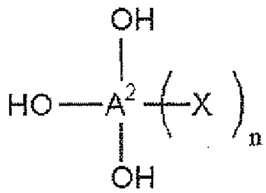

(V)

In Formulae (III) to (V), X represents a methacryl group, an acryl group, an allyl group, a styryl group or a vinyl group, and preferably a methacryl group, an acryl group or a styryl group. n represents an integer from 1 to 12, preferably from 2 to 8, and more preferably from 3 to 6.

$A^2$ represents a trivalent to tetradecavalent organic residue constituted of nonmetal atoms and includes those constituted of at least one kind of elements selected from 2 to 30 carbon atoms, up to 10 nitrogen atoms, up to 10 oxygen atoms, up to 10 halogen atoms, up to 10 silicon atoms, from 2 to 100 hydrogen atoms, up to 10 phosphorus atoms and up to 10 sulfur atoms. Among them, combinations of from 3 to 20 carbon atoms, up to 5 nitrogen atoms, up to 10 oxygen atoms and from 2 to 40 hydrogen atoms are preferred. Trivalent to tetradecavalent organic residues composed of the atoms and structures in connecting groups shown above and combinations thereof are preferred.

(B) Component may contain a hydrophilic group, for example, a sulfo group, a polyoxyalkylene group, a hydroxy group, a group having a betaine structure, an amido group or an ammonium group.

Specific examples of (B) component are set forth below, but the invention should not be construed as being limited thereto.

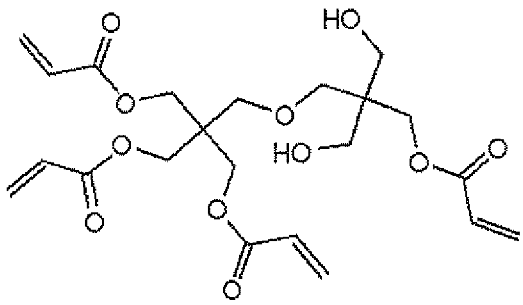

(B-1)

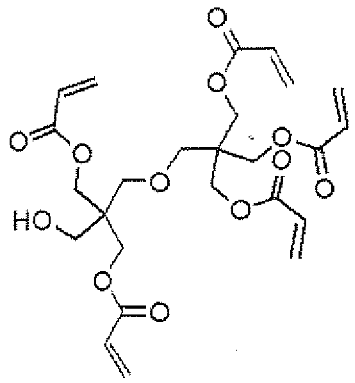

(B-2)

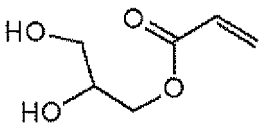
(B-3)

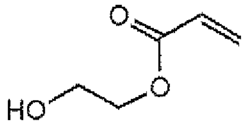
(B-4)

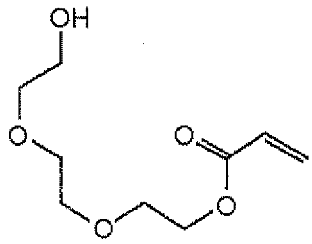
(B-5)

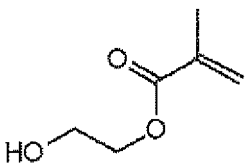
(B-6)

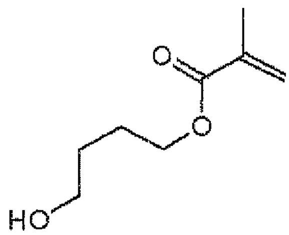
(B-7)

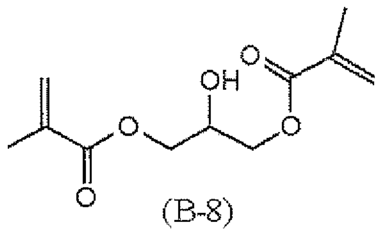
(B-8)

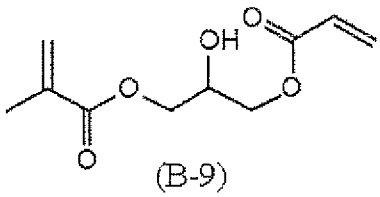
(B-9)

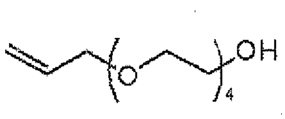
(B-10)

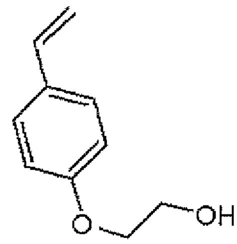
(B-11)

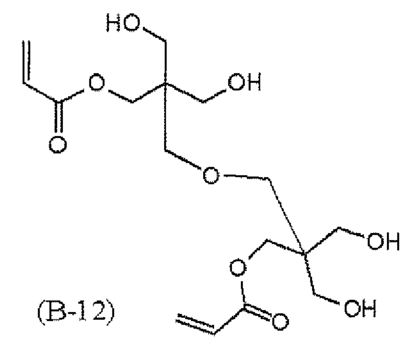
(B-12)

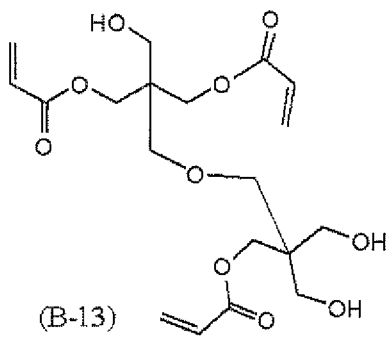
(B-13)

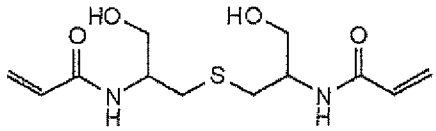

(B-14)

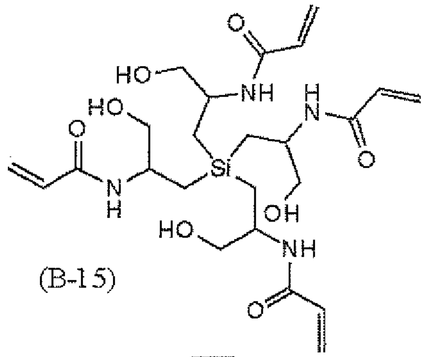

(B-15)

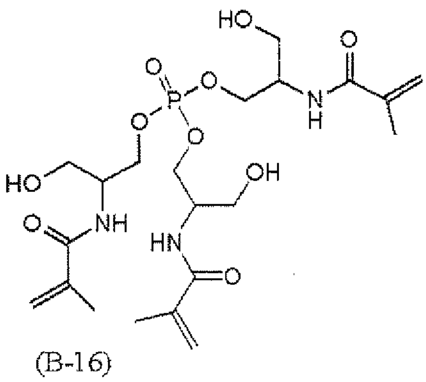

(B-16)

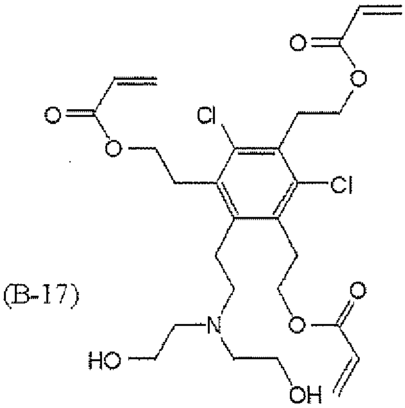

(B-17)

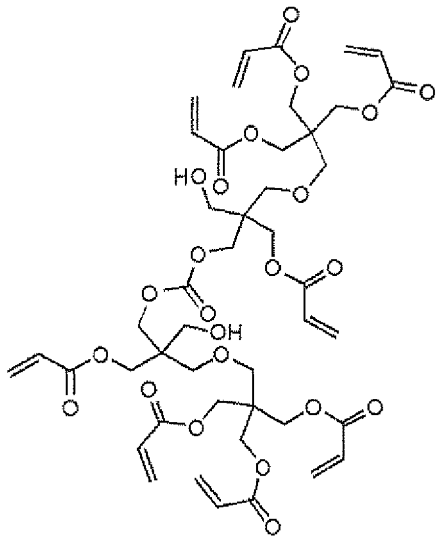

(B-18)

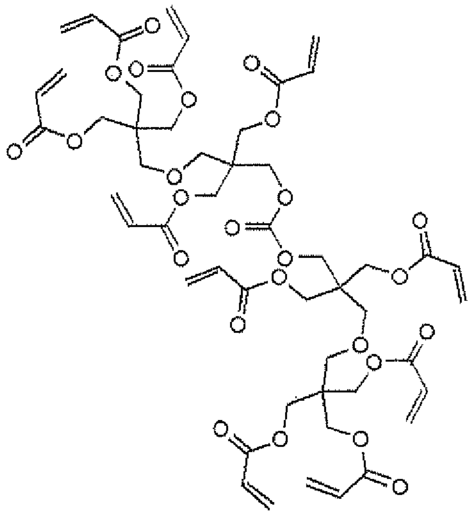

(B-19)

<(C) Compound having hydrophilic group and hydroxy group [(C) component]>

As (C) component, any compound having a hydrophilic group and a hydroxy group is suitably used and compounds having from 1 to 4 hydroxy groups are preferred, compounds having from 1 to 3 hydroxy groups are more preferred, and compounds having 1 or 2 hydroxy groups are particularly preferred.

Specific examples of preferred (C) component include compounds represented by formulae (VI) to (IX) shown below.

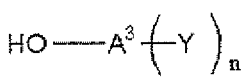
(VI)

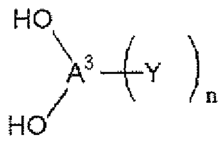
(VII)

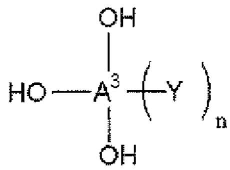
(VIII)

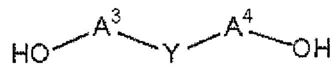
(IX)

In formulae (VI) to (IX), n represents an integer from 1 to 12, preferably from 1 to 8, and more preferably from 1 to 6.

$A^3$ and $A^4$ each independently represents a divalent to tetradecavalent organic residue constituted of nonmetal atoms and includes those constituted of at least one kind of elements selected from 3 to 30 carbon atoms, up to 10 nitrogen atoms, up to 10 oxygen atoms, up to 10 halogen atoms, up to 10 silicon atoms, from 3 to 100 hydrogen atoms, up to 10 phosphorus atoms and up to 10 sulfur atoms. Among them, combinations of from 3 to 20 carbon atoms, up to 5 nitrogen atoms, up to 10 oxygen atoms and from 2 to 50 hydrogen atoms are preferred. Divalent to tetradecavalent organic residues composed of the atoms and structures in connecting groups shown above and combinations thereof are preferred.

Y represents a hydrophilic group selected from a sulfo group, a sulfonate group, a group having a polyoxyalkylene chain, a hydroxy group, an amido group, an ammonium group or a group having a betaine structure, preferably a group having a polyoxyalkylene chain, a hydroxy group, an amido group or a group having a betaine structure, and most preferably a polyoxyalkylene group, an amido group or a group having a betaine structure.

As the polyoxyalkylene group, a polyoxyethylene group and a polyoxypropylene group are preferred, and polyoxyethylene group is particularly preferred. The number of the oxyethylene repeating unit is preferably from 2 to 100, more preferably from 2 to 50, and most preferably from 2 to 20.

As the amido group, an unsubstituted amido or a mono-substituted amido having a substituent on the nitrogen atom is preferred. As the substituent, an alkyl group having from 1 to 10 carbon atoms or a hydroxy alkyl group having from 1 to 10 carbon atoms is preferred, an alkyl group having from 1 to 8 carbon atoms or a hydroxy alkyl group having from 1 to 8 carbon atoms is more preferred, and an alkyl group having from 1 to 6 carbon atoms or a hydroxy alkyl group having from 1 to 6 carbon atoms is most preferred.

As the betaine structure, any betaine structure is suitably used and in particular, a sulfobetaine, a phosphobetaine or a carbobetaine is preferred, a sulfobetaine or a phosphobetaine is more preferred, and a sulfobetaine is most preferred.

Specific examples of (C) component are set forth below, but the invention should not be construed as being limited thereto.

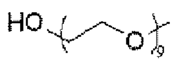
(C-1)

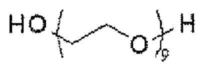
(C-2)

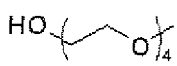
(C-3)

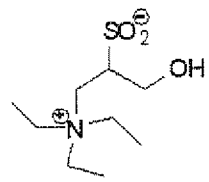
(C-4)

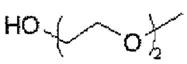
(C-5)

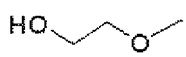
(C-6)

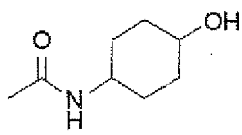
(C-7)

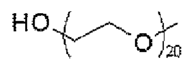
(C-9)

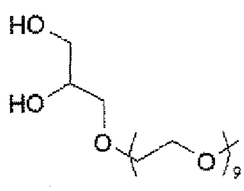
(C-8)

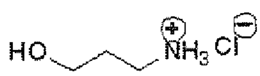
(C-10)

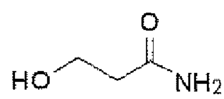
(C-11)

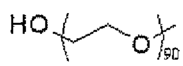
(C-12)

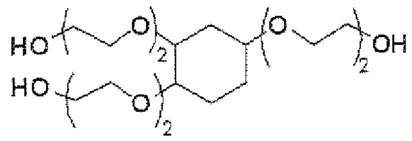
(C-13)

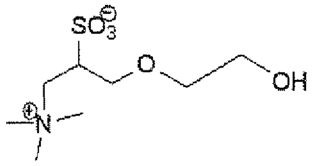
(C-14)

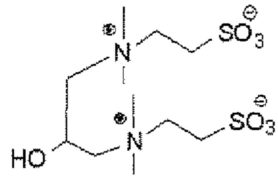
(C-15)

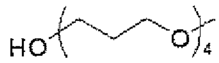
(C-16)

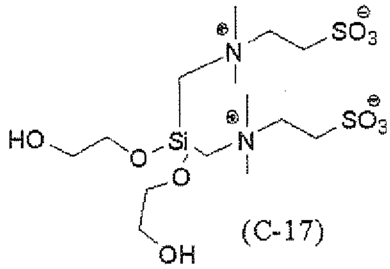
(C-17)

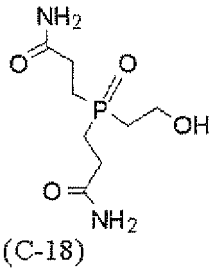
(C-18)

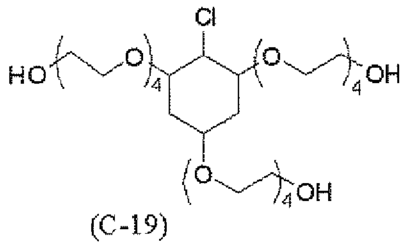
(C-19)

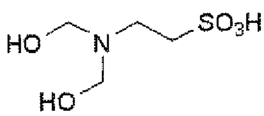
(C-20)

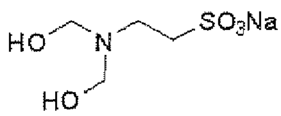
(C-21)

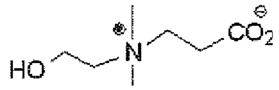
(C-22)

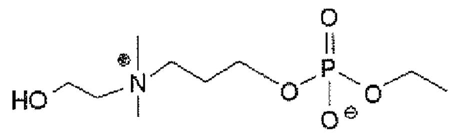
(C-23)

As (C) component having a polyoxyalkylene group, in addition to the structures shown above, polypropylene glycol, polyethylene glycol, polytetramethylene glycol, ethyleneoxide-propyleneoxide copolymer, tetrahydrofuran-ethyleneoxide copolymer, tetrahydrofuran-propyleneoxide copolymer and a polyester diol (for example, polyethylene adipate, polydiethylene adipate, polypropylene adipate, polyhexamethylene adipate, polyneopentyl adipate, polyhexamethylene neopentyl adipate, polyethylene diethylene adipate, polyethylene hexamethylene adipate poly-ε-caprolactone diol, polyhexamethylenecarbonate diol or polytetramethylene adipate) are typically exemplified.

The compound where the hydrophilic group is a hydroxy group is a polyhydric alcohol and can be used as (C) component. Specific examples of the polyhydric alcohol include propane diol, butane diol, pentane diol, pentane triol, hexane diol, hexane triol, glycerin, diglycerin, triglycerin, cyclohexane diol, cyclohexane triol, pentaerythritol, trimethylol propane and a sugar alcohol, for example, sorbitol or mannitol. The polyhydric alcohol may be substituted, for example, with a halogen atom, an alkoxy group, an amino group, a substituted amino group, a substituted carbonyl group, a hydroxy group, a substituted oxy group, a mercapto group, a substituted thio group, a silyl group, a nitro group, a cyano group, an alkyl group, an alkenyl group, an alkynyl group, an aryl group or a heterocyclic group.

<(D) Other component [(D) component]>

The radical polymerizable urethane oligomer according to the invention may be synthesized by adding (D) other component in addition to (A) component, (B) component and (C) component. (D) Component is not particularly restricted and preferably includes a monoisocyanate compound, a diisocyanate compound and a monohydric alcohol.

As the monoisocyanate compound, an isocyanate having an alkyl group having from 1 to 20 carbon atoms or an aryl group is exemplified. The isocyanate may be substituted with a substituent, for example, a halogen atom, an alkoxy group or an alkylthio group. Specific examples thereof include phenyl isocyanate, m-toluene isocyanate, ethyl

isocyanate and n-propyl isocyanate.

As the diisocyanate, for example, tolylene diisocyanate, xylylene diisocyanate, diphenylmethane diisocyanate, hexamethylene diisocyanate, isophorone diisocyanate, diphenylether diisocyanate, hydrogenated xylylene diisocyanate, cyclohexane diisocyanate, hydrogenated diphenylmethane diisocyanate, tetramethylxylylene diisocyanate or lysine diisocyanate is exemplified.

As the monohydric alcohol, an alcohol which does not have the hydrophilic group described in (C) component is exemplified. In addition to an alcohol having a straight-chain or branched alkyl group having from 1 to 20 carbon atoms, an alcohol having a substituent described below is preferably used. The substituent includes, for example, a halogen atom, an alkoxy group, an amino group, a substituted amino group, a substituted carbonyl group, a hydroxy group, a substituted oxy group, a mercapto group, a substituted thio group, a silyl group, a nitro group, a cyano group, an alkenyl group, an alkynyl group, an aryl group and a heterocyclic group, and the substituent may further have a substituent when it can be introduced. Specific examples thereof include, methanol, ethanol, n-propanol, isopropanol, n-butanol, tert-butanol, 3-chloropropanol, 3-bromopropanol, methoxymethanol, 2-methoxyethanol, 2-ethoxyethanol, benzyl alcohol, 4-chlorobenzyl alcohol, 4-methoxybenzyl alcohol, 2-chloro-2-propenyl alcohol, methallyl alcohol, crotyl alcohol, prenyl alcohol and 3-methoxy-2-propenyl alcohol.

In the hydroxy group value (the sum of mole number of the hydroxy groups contained in each of (B), (C) and (D) components), a ratio of (B) component is preferably from 10 to 60% by mole, more preferably from 20 to 60% by mole, and most preferably from 25 to 55% by mole. A ratio of (C) component is preferably from 20 to 60% by mole, more preferably from 20 to 55% by mole, and most preferably from 25 to 55% by mole.

In the synthesis of the radical polymerizable urethane oligomer, a ratio of the isocyanate value (mole number of the isocyanate group contained in (A) component)/the hydroxy group value is preferably from 1/1 to 1/5, more preferably from 1/1 to 1/4, and most preferably from 1/1 to 1/3.

The content of the radical polymerizable urethane oligomer in the image-recording layer is preferably from 3 to 90% by weight, more preferably from 5 to 80% by weight, still more preferably from 10 to 75% by weight, most preferably from 15 to 70% by weight, based on the total solid content of the image-recording layer.

For the purpose of controlling the molecular weight of the radical polymerizable urethane oligomer according to the invention, it is possible to terminate the reaction by adding a large amount of alcohol during the reaction.

(a) Infrared absorbing agent

The infrared absorbing agent has a function of converting the infrared ray absorbed to heat and a function of being excited by the infrared ray to perform electron transfer and/or energy transfer to the radical polymerization initiator described below. The infrared absorbing agent for use in the invention is a dye having an absorption maximum in a wavelength range from 760 to 1,200 nm.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As a particularly preferable example of the dye, a cyanine dye represented by formula (a) shown below is exemplified.

Formula (a):

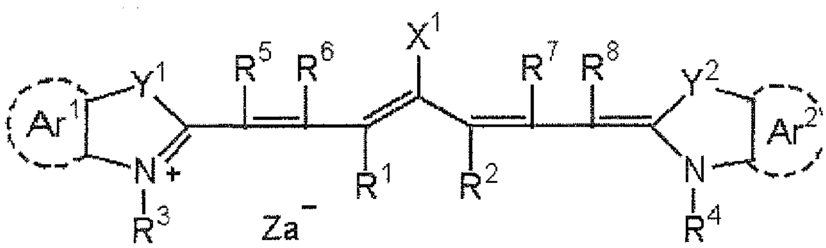

In formula (a), $X^1$ represents a hydrogen atom, a halogen atom, $-N(R^9)(R^{10})$, $X^2-L^1$ or a group shown below. $R^9$ and $R^{10}$, which may be the same or different, each represents an aryl group having from 6 to 10 carbon atoms, which

may have a substituent, an alkyl group having from 1 to 8 carbon atoms, which may have a substituent or a hydrogen atom, or $R^9$ and $R^{10}$ may be combined with each other to form a ring. Above all, a phenyl group is preferred ($-NPh_2$). $X^2$ represents an oxygen atom or a sulfur atom, $L^1$ represents a hydrocarbon group having from 1 to 12 carbon atoms, a hetero aryl group or a hydrocarbon group having from 1 to 12 carbon atoms and containing a hetero atom. The hetero atom used herein indicates a nitrogen atom, a sulfur atom, an oxygen atom, a halogen atom and a selenium atom. In the group shown below, $Xa^-$ has the same meaning as $Za^-$ defined hereinafter, and $R^a$ represents a hydrogen atom or a substituent selected from an alkyl group, an aryl group, a substituted or unsubstituted amino group and a halogen atom.

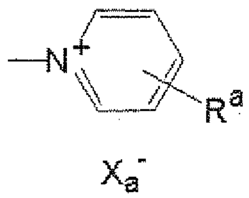

$R^1$ and $R^2$ each independently represents a hydrocarbon group having from 1 to 12 carbon atoms. In view of the preservation stability of a coating solution for image-recording layer, it is preferred that $R^1$ and $R^2$ each represent a hydrocarbon group having two or more carbon atoms. Also, $R^1$ and $R^2$ may be combined with each other to form a ring and in case of forming the ring, to form a 5-membered ring or 6-membered ring is particularly preferred.

$Ar^1$ and $Ar^2$, which may be the same or different, each represents an aryl group which may have a substituent. Preferable examples of the aryl group include a benzene ring group and a naphthalene ring group. Also, preferable examples of the substituent include a hydrocarbon group having 12 or less carbon atoms, a halogen atom and an alkoxy group having 12 or less carbon atoms. $Y^1$ and $Y^2$, which may be the same or different, each represents a sulfur atom or a dialkylmethylene group having 12 or less carbon atoms. $R^3$ and $R^4$, which may be the same or different, each represents a hydrocarbon group having 20 or less carbon atoms, which may have a substituent. Preferable examples of the substituent include an alkoxy group having 12 or less carbon atoms, a carboxyl group and a sulfo group. $R^5$, $R^6$, $R^7$ and $R^8$, which may be the same or different, each represents a hydrogen atom or a hydrocarbon group having 12 or less carbon atoms. In view of the availability of raw materials, a hydrogen atom is preferred. $Za^-$ represents a counter anion. However, $Za^-$ is not necessary when the cyanine dye represented by formula (a) has an anionic substituent in the structure thereof and neutralization of charge is not needed. In view of the preservation stability of a coating solution for image-recording layer, preferable examples of the counter ion for $Za^-$ include a halide ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion.

Specific examples of the cyanine dye represented by formula (a), which can be preferably used, include compounds described in Paragraph Nos. [0017] to [0019] of JP-A-2001-133969, Paragraph Nos. [0016] to [0021] of JP-A-2002-23360 and Paragraph Nos. [0012] to [0037] of JP-A-2002-40638, preferably compounds described in Paragraph Nos. [0034] to [0041] of JP-A-2002-278057 and Paragraph Nos. [0080] to [0086] of JP-A-2008-195018, and most preferably compounds described in Paragraph Nos. [0035] to [0043] of JP-A-2007-90850.

Also, compounds described in Paragraph Nos. [0008] to [0009] of JP-A-5-5005 and Paragraph Nos. [0022] to [0025] of JP-A-2001-222101 are preferably used.

The infrared absorbing dyes may be used only one kind or in combination of two or more kinds thereof and it may also be used together with an infrared absorbing agent other than the infrared absorbing dye, for example, a pigment. As the pigment, compounds described in Paragraph Nos. [0072] to [0076] of JP-A-2008-195018 are preferred.

The content of the infrared absorbing agent in the image-recording layer according to the invention is preferably from 0.1 to 10.0% by weight, more preferably from 0.5 to 5.0% by weight, based on the total solid content of the image-recording layer. (b) Radical polymerization initiator

The radical polymerization initiator (b) for use in the invention is a compound which initiates or accelerates polymerization of the radical polymerizable urethane oligomer (d). The radical polymerization initiator for use in the invention includes, for example, known thermal polymerization initiators, compounds containing a bond having small bond dissociation energy and photopolymerization initiators.

The radical polymerization initiators in the invention include, for example, (a) organic halides, (b) carbonyl compounds, (c) azo compounds, (d) organic peroxides, (e) metallocene compounds, (f) azido compounds, (g) hexaarylbiimidazole compounds, (h) organic borate compounds, (i) disulfone compounds, (j) oxime ester compounds and (k) onium salt compounds.

As the organic halides (a), compounds described in Paragraph Nos. [0022] to [0023] of JP-A-2008-195018 are preferred.

As the carbonyl compounds (b), compounds described in Paragraph No. [0024] of JP-A-2008-195018 are

preferred.

As the azo compounds (c), for example, azo compounds described in JP-A-8-108621 are used.

As the organic peroxides (d), for example, compounds described in Paragraph No. [0025] of JP-A-2008-195018 are preferred.

As the metallocene compounds (e), for example, compounds described in Paragraph No. [0026] of JP-A-2008-195018 are preferred.

As the azido compounds (f), compound, for example, 2,6-bis(4-azidobenzylidene)-4-methylcyclohexanone is exemplified.

As the hexaarylbiimidazole compounds (g), for example, compounds described in Paragraph No. [0027] of JP-A-2008-195018 are preferred.

As the organic borate compounds (h), for example, compounds described in Paragraph No. [0028] of JP-A-2008-195018 are preferred.

As the disulfone compounds (i), for example, compounds described in JP-A-61-166544 are exemplified.

As the oxime ester compounds (j),for example, compounds described in Paragraph Nos. [0028] to [0030] of JP-A-2008-195018 are preferred.

As the onium salt compounds (k), onium salts, for example, diazonium salts described in S. I. Schlesinger, Photogr. Sci. Eng., 18, 387 (1974) and T. S. Bal et al., Polymer, 21, 423 (1980) and JP-A-5-158230, ammonium salts described in U.S. Patent 4,069,055 and JP-A-4-365049, phosphonium salts described in U.S. Patents 4,069,055 and 4,069,056, iodonium salts described in European Patent 104,143, U. S. Patent Publication No. 2008/0311520, JP-A-2-150848, JP-A-2008-195018 and J.V. Crivello et al., Macromolecules, 10 (6), 1307 (1977), sulfonium salts described in European Patents 370,693, 233,567, 297,443 and 297,442, U.S. Patents 4,933,377, 4,760,013, 4,734,444 and 2,833,827, German Patents 2,904,626, 3,604,580 and 3,604,581, selenonium salts described in J.V. Crivello et al., J. Polymer Sci., Polymer Chem. Ed., 17, 1047 (1979), arsonium salts described in C.S. Wen et al., Teh, Proc. Conf. Rad. Curing ASIA, p. 478, Tokyo, Oct. (1988), and azinium salts described in JP-A-2008-195018 are exemplified.

Of the radical polymerization initiators, the onium salts, particularly, the iodonium salts, sulfonium salts and azinium salts are preferred. Specific examples of these compounds are set forth below, but the invention should not be construed as being limited thereto.

Of the iodonium salts, a diphenyliodonium salt is preferred. In particular, a diphenyliodonium salt substituted with an electron donating group, for example, an alkyl group or an alkoxy group is preferred, and an asymmetric diphenyliodonium salt is more preferred. Specific examples of the iodonium salt include diphenyliodonium hexafluorophosphate, 4-methoxyphenyl-4-(2-methylpropyl)phenyliodonium hexafluorophosphate, 4-(2-methylpropyl)phenyl-p-tolyliodonium hexafluorophosphate, 4-hexyloxyphenyl-2,4,6-trimethoxyphenyliodonium hexafluorophosphate, 4-hexyloxyphenyl-2,4-diethoxyphenyliodonium tetrafluoroborate, 4-octyloxyphenyl-2,4,6-trimethoxyphenyliodonium 1-perfluorabutanesulfonate, 4-octyloxyphenyl-2,4,6-trimethoxyphenyliodonium hexafluorophosphate and bis(4-tert-butylphenyl)iodonium tetraphenylborate.

Examples of the sulfonium salt include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate, tris(4-chlorophenyl)sulfonium 3,5-bis(methoxycarbonyl)benzenesulfonate and tris(4-chlorophenyl)sulfonium hexafluorophosphate.

Examples of the azinium salt include 1-cyclohexylmethyloxypyridinium hexafluorophosphate, 1-cyclohexyloxy-4-phenylpyridinium hexafluorophosphate, 1-ethoxy-4-phenylpyridinium hexafluorophosphate, 1-(2-ethylhexyloxy)-4-phenylpyridinium hexafluorophosphate, 4-chloro-1-cyclohexylmethyloxypyridinium hexafluorophosphate, 1-ethoxy-4-cyanopyridinium hexafluorophosphate, 3,4-dichloro-1-(2-ethylhexyloxy)pyridinium hexafluorophosphate, 1-benzyloxy-4-phenylpyridinium hexafluorophosphate, 1-phenethyloxy-4-phenylpyridinium hexafluorophosphate, 1-(2-ethylhexyloxy)-4-phenylpyridinium p-toluenesulfonate, 1-(2-ethylhexyloxy)-4-phenylpyridinium perfluorobutanesulfonate, 1-(2-ethylhexyloxy)-4-phenylpyridinium bromide and 1-(2-ethylhexyloxy)-4-phenylpyridinium tetrafluoroborate.

The radical polymerization initiator can be added to the image-recording layer preferably in an amount from 0.1 to 50% by weight, more preferably from 0.5 to 30% by weight, particularly preferably from 0.8 to 20% by weight, based on the total solid content of the image-recording layer. In the range described above, good sensitivity and good stain resistance in the non-image area at the time of printing are obtained.

(c) Polymer particle

According to the invention, a polymer particle can be used in order to improve the on-press development property. As the polymer particle, any polymer particle may be used and a latex and a microcapsule described below are preferably exemplified.

As the latex, polymer particles described, for example, in Research Disclosure, No. 33303, January (1992), JP-A-9-123387, JP-A-9-131850, JP-A-9-171249, JP-A-9-171250 and European Patent 931,647 are preferably exemplified.

Specific examples of the polymer constituting the latex include a homopolymer or copolymer containing a monomer unit selected from ethylene, styrene, vinyl chloride, methyl acrylate, ethyl acrylate, methyl methacrylate, ethyl methacrylate, vinylidene chloride, a monomer having a cyano group and vinyl carbazole, and a mixture thereof Among them, a homopolymer or copolymer containing a monomer unit selected from styrene, acrylonitrile and methyl methacrylate is preferred. From the standpoint of the printing durability, a homopolymer or copolymer containing acrylonitrile as a monomer unit is particularly preferred.

Also, a latex having a polyoxyalkylene chain is preferred. Particularly, a polymer particle having a polyoxyalkylene chain in its side chain is preferred. Specifically, a polymer particle containing as a copolymerization unit an acrylate or methacrylate unit having a polyoxyalkylene chain is preferred. Due to the polyoxyalkylene chain, the permeability of dampening water increases to improve the on-press development property. Of the polyoxyalkylene chains, a polyoxyethylene chain having ethyleneoxide units from 2 to 20 is more preferred.

In order for the image-recording layer containing a polymer particle to form a strong image, it is preferred to provide a reactive group on the polymer particle so that the polymer particle can react at the time of image exposure. As the reactive group, an ethylenically unsaturated group (for example, an acryloyl group, a methacryloyl group, a vinyl group or an allyl group), a cationic polymerizable group (for example, a vinyl group, a vinyloxy group, an epoxy group or an oxetanyl group), an isocyanate group or a blocked form thereof, an epoxy group or a vinyloxy group performing an addition reaction and a functional group having an active hydrogen atom (for example, an amino group, a hydroxy group or a carboxyl group) as the reaction partner thereof, a carboxyl group performing a condensation reaction and a hydroxyl group or an amino group as the reaction partner thereof, and an acid anhydride performing a ring opening addition reaction and an amino group or a hydroxyl group as the reaction partner thereof are preferably exemplified.

Of the reactive groups, an ethylenically unsaturated group is particularly preferred. By providing the ethylenically unsaturated group to the polymer particle, the polymer particle is also involved in the polymerization reaction at the time of image exposure so that the printing durability can be improved.

The synthesis method of the latex for use in the invention includes (1) emulsion polymerization conducting mixing a medium, for example, water with a monomer hardly soluble in the medium and a emulsifier (surfactant) and adding thereto a polymerization initiator (ordinarily a radical generator) soluble in the medium, and (2) suspension polymerization which is a polymerization method conducting in a suspension prepared by mechanically stirring a monomer and a medium, for example, water.

According to the invention, a microcapsule can also be used as the polymer particle. For example, microcapsules having all or part of the constituting components of the image-recording layer encapsulated as described in JP-A-2001-277740 and JP-A-2001-277742 are exemplified. Methods of producing the microcapsule include, for example, a method of utilizing coacervation described in U.S. Patents 2,800,457 and 2,800,458, a method of using interfacial polymerization described in British Patent 990,443, U.S. Patent 3,287,154, JP-B-38-19574, JP-B-42-446 and JP-B-42-711, a method of using deposition of polymer described in U.S. Patents 3,418,250 and 3,660,304, a method of using an isocyanate polyol wall material described in U.S. Patent 3,796,669, a method of using an isocyanate wall material described in U.S. Patent 3,914,511, a method of using a urea-formaldehyde-type or urea-formaldehyde-resorcinol-type wall-forming material described in U.S. Patens 4,001,140, 4,087,376 and 4,089,802, a method of using a wall material, for example, a melamine-formaldehyde resin or hydroxycellulose described in U.S. Patent 4,025,445, an in-situ method by monomer polymerization described in JP-B-36-9163 and JP-B-51-9079, a spray drying method described in British Patent 930,422 and U.S. Patent 3,111,407, and an electrolytic dispersion cooling method described in British Patents 952,807 and 967,074, but the invention should not be construed as being limited thereto.

A preferable microcapsule wall has three-dimensional crosslinking and has a solvent-swellable property. From this point of view, a preferable wall material of the microcapsule includes polyurea, polyurethane, polyester, polycarbonate, polyamide and a mixture thereof, and polyurea and polyurethane are particularly preferred.

With respect to the microcapsule according to the invention, a solvent which dissolves the compound encapsulated and swells the wall material can be added to the dispersion medium in the production thereof. By the solvent, diffusion of the compound encapsulated to the outside of the microcapsule is accelerated. The solvent may depend on the dispersion medium of microcapsule, wall material of microcapsule, wall thickness and compound encapsulated, but can be easily selected from many commercially available solvents. For instance, in case of a water dispersing microcapsule having a crosslinked polyurea or polyurethane wall, for example, an alcohol, an ether, an acetal, an ester, a ketone, a polyhydric alcohol, an amide, an amine or a fatty acid is preferred.

Specific examples thereof include methanol, ethanol, tertiary butanol, n-propanol, tetrahydrofuran, methyl lactate, ethyl lactate, methyl ethyl ketone, propylene glycol monomethyl ether, ethylene glycol diethyl ether, ethylene glycol monomethyl ether, γ-butyrolactone, N,N-dimethylformamide and N,N-dimethylacetamide, but the invention should not be construed as being limited thereto. The solvents may be used in mixture of two or more thereof. A solvent which does not dissolve in a microcapsule dispersion but dissolves by mixing the solvent described above is also used. The amount of the solvent added may be determined by the combination of materials and when it is smaller than the adequate value,

the formation of image may become insufficient, whereas when it is too large, stability of the dispersion may deteriorate. Ordinarily, it is effective in a range from 5 to 95% by weight, preferably in a range from 10 to 90% by weight, more preferably in a range from 15 to 85% by weight, of the coating solution.

In order to sufficiently exhibit the function of the radical polymerizable urethane oligomer in the invention, it is essential to add the radical polymerizable urethane oligomer so as to be present outside of the polymer particle, for example, a microcapsule or a latex.

The average particle size of the polymer particle is preferably from 0.01 to 3.0 μm, more preferably from 0.05 to 2.0 μm, particularly preferably from 0.10 to 1.0 μm. In the range described above, good resolution and time-lapse stability are obtained.

The content of the polymer particle is preferably in a range from 5 to 90% by weight based on the total solid content of the image-recording layer.

(F) Other components

(1) Radical polymerizable compound other than radical polymerizable urethane oligomer described above

A known radical polymerizable compound other than the radical polymerizable urethane oligomer described above may be used as the radical polymerizable compound in the image-recording layer according to the invention. Such a radical polymerizable compound includes, radical polymerizable compounds described, for example, in JP-A-2002-287334 and JP-A-2005-329708. More specifically, an ester of a polyvalent alcohol and acrylic acid, an amide of polyvalent amine and acrylic acid and a polymerizable compound having an isocyanuric acid skeleton, for example, isocyanuric acid ethyleneoxide-modified acrylate. Further, of urethane type polymerizable compounds, for example, those not having a hydrophilic group and those having a molecular weight of less than 1,500 may be used.

The content of the radical polymerizable compound other than the radical polymerizable urethane oligomer is preferably 10% by mole or less of the radical polymerizable urethane oligomer.

(2) Binder polymer

In the image-recording layer according to the invention, a binder polymer may be used for the purpose of improving film strength of the image-recording layer. The binder polymer which can be used in the invention can be selected from those heretofore known without restriction, and polymers having a film-forming property are preferred. Among them, acrylic resins, polyvinyl acetal resins and polyurethane resins are preferred.

As the binder polymer preferable for the invention, a polymer having a crosslinkable functional group for improving film strength of the image area in its main chain or side chain, preferably in its side chain, as described in JP-A-2008-195018 is exemplified. Due to the crosslinkable functional group, crosslinkage is formed between the polymer molecules to facilitate curing.

As the crosslinkable functional group, an ethylenically unsaturated group, for example, a (meth)acryl group, a vinyl group, an allyl group or a styryl group or an epoxy group is preferred. The crosslinkable functional group can be introduced into the polymer by a polymer reaction or copolymerization. For instance, a reaction between an acrylic polymer or polyurethane having a carboxyl group in its side chain and glycidyl methacrylate or a reaction between a polymer having an epoxy group and a carboxylic acid containing an ethylenically unsaturated group, for example, methacrylic acid can be utilized.

The content of the crosslinkable group in the binder polymer is preferably from 0.1 to 10.0 mmol, more preferably from 0.25 to 7.0 mmol, most preferably from 0.5 to 5.5 mmol, based on 1 g of the binder polymer.

It is also preferred that the binder polymer for use in the invention further contain a hydrophilic group. The hydrophilic group contributes to impart the on-press development property to the image-recording layer. In particular, coexistence of the crosslinkable group and the hydrophilic group makes it possible to maintain good balance between printing durability and developing property.

The hydrophilic group includes, for example, a hydroxy group, a carboxyl group, an alkylene oxide structure, an amino group, an ammonium group, an amido group, a sulfo group and a phosphoric acid group. Among them, an alkylene oxide structure containing from 1 to 9 alkylene oxide units having 2 or 3 carbon atoms is preferable. In order to introduce a hydrophilic group into the binder polymer, a monomer having the hydrophilic group may be copolymerized.

In order to control the ink-receptive property, an oleophilic group, for example, an alkyl group, an aryl group, an aralkyl group or an alkenyl group may be introduced into the binder polymer according to the invention. Specifically, an oleophilic group-containing monomer, for example, an alkyl methacrylate may be copolymerized.

Specific examples (1) to (11) of the binder polymer for use in the invention are set forth below, but the invention should not be construed as being limited thereto.

(1) 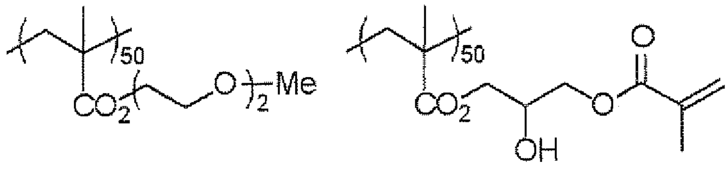

(2) 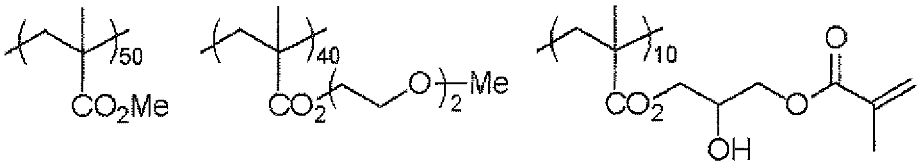

(3) 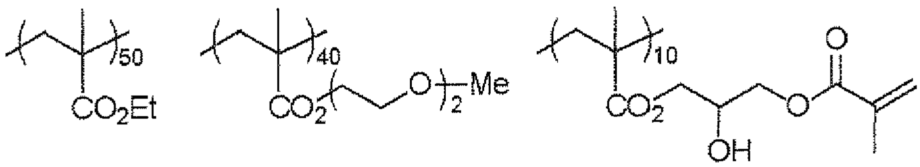

(4) 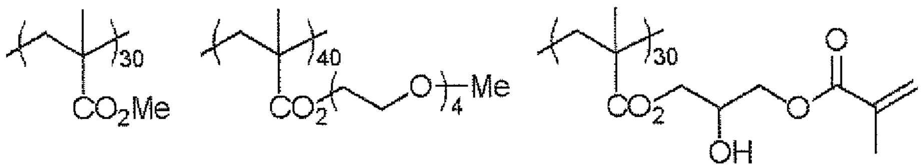

(5) 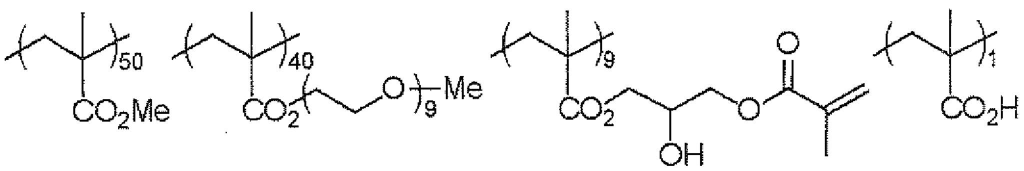

(6) 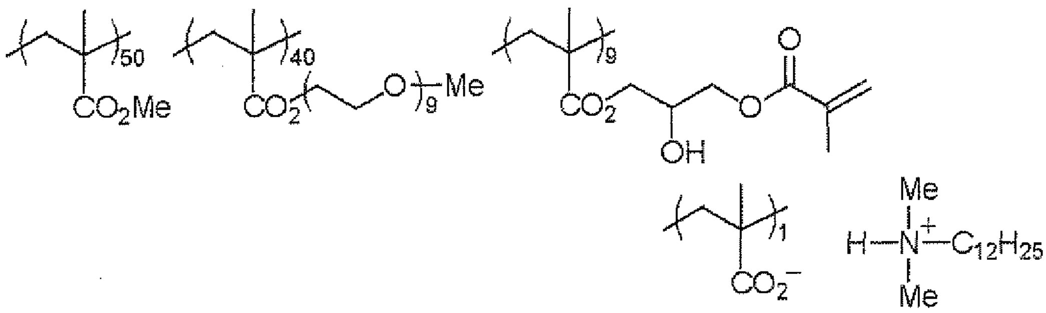

(7) 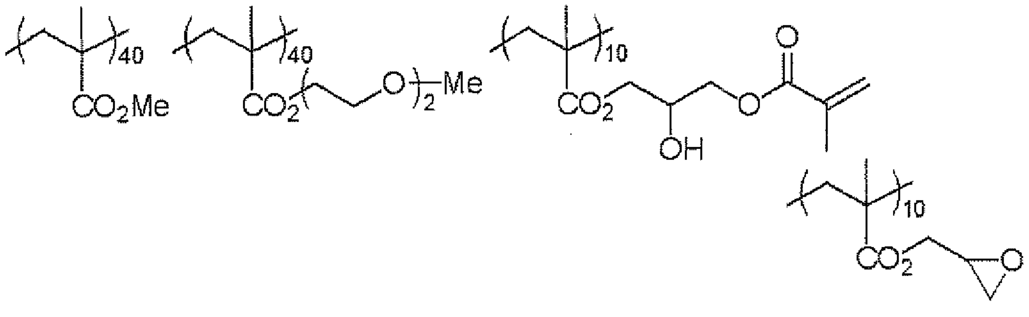

(8) 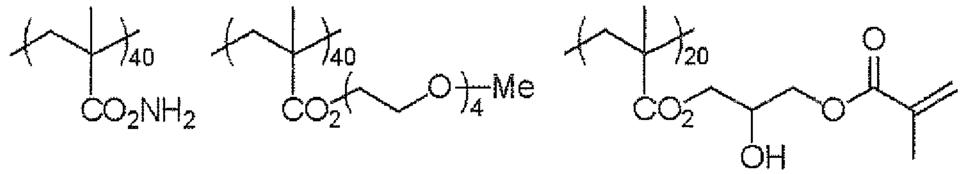

(9) 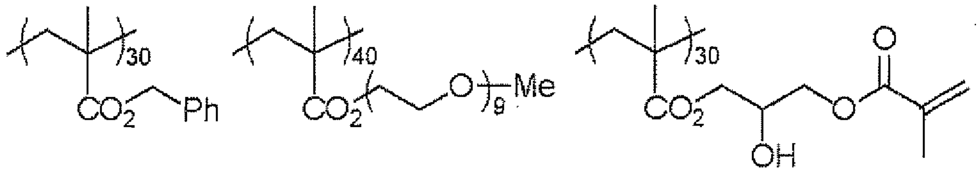

(10) 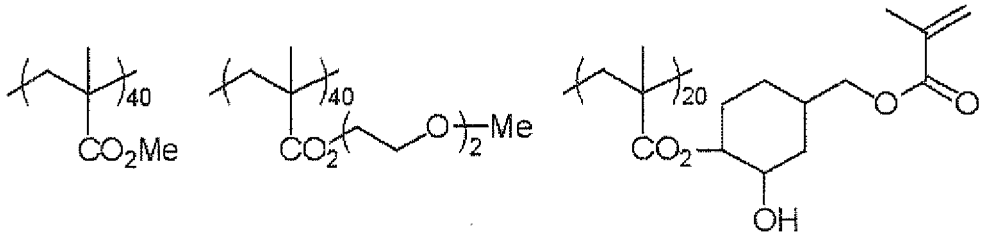

(11) 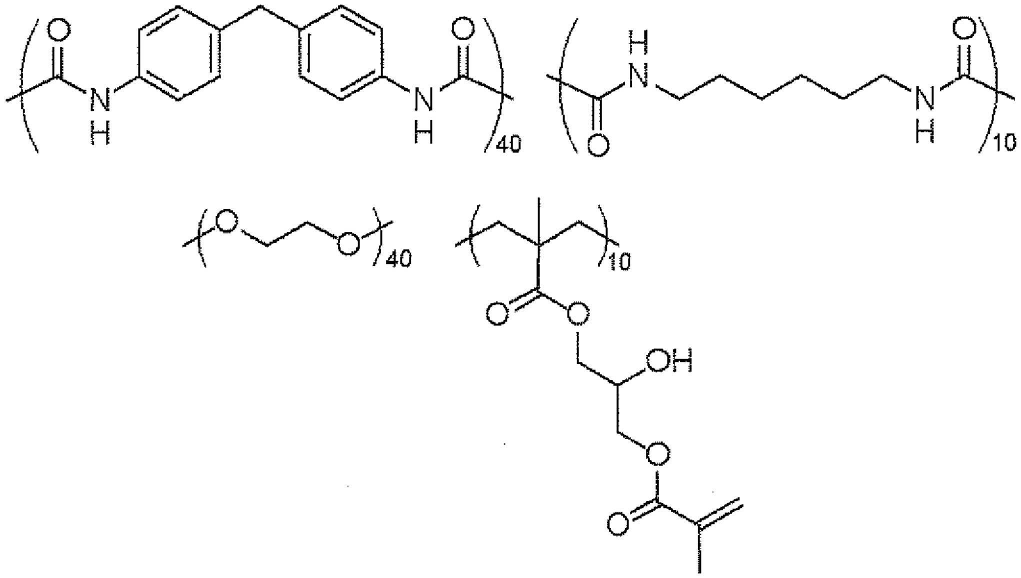

The weight average molecular weight (Mw) of the binder polymer according to the invention is preferably 2,000 or more, more preferably 5,000 or more, and still more preferably from 10,000 to 300,000.

According to the invention, a hydrophilic polymer, for example, polyacrylic acid or polyvinyl alcohol described in JP-A-2008-195018 may be used, if desired. Further, an oleophilic binder polymer is used together with a hydrophilic binder polymer.

The content of the binder polymer is preferably from 5 to 90% by weight, more preferably from 5 to 80% by weight, still more preferably from 10 to 70% by weight, based on the total solid content of the image-recording layer.

Although the binder polymer may be used, the content of the binder polymer is preferably 10% by mole of less of the radical polymerizable urethane oligomer. (3) Hydrophilic low molecular weight compound

The image-recording layer according to the invention may contain a hydrophilic low molecular weight compound in order to improve the on-press development property without accompanying the decrease in the printing durability.

The hydrophilic low molecular weight compound includes a water-soluble organic compound, for example, a glycol compound, e.g., ethylene glycol, diethylene glycol, triethylene glycol, propylene glycol, dipropylene glycol or tripropylene glycol, or an ether or ester derivative thereof, a polyol compound, e.g., glycerine, pentaerythritol or tris(2-hydroxyethyl) isocyanurate, an organic amine compound, e.g., triethanol amine, diethanol amine or monoethanol amine,

or a salt thereof, an organic sulfonic acid compound, e.g., an alkyl sulfonic acid, toluene sulfonic acid or benzene sulfonic acid, or a salt thereof, an organic sulfamic acid compound, e.g., an alkyl sulfamic acid, or a salt thereof, an organic sulfuric acid compound, e.g., an alkyl sulfuric acid or an alkyl ether sulfuric acid, or a salt thereof, an organic phosphonic acid compound, e.g., phenyl phosphonic acid, or a salt thereof, an organic carboxylic acid, e.g., tartaric acid, oxalic acid, citric acid, malic acid, lactic acid, gluconic acid or an amino acid, or a salt thereof and a betaine compound.

According to the invention, it is preferred that at least one compound selected from a polyol compound, an organic sulfate compound, an organic sulfonate compound and a betaine compound is incorporated.

Specific examples of the organic sulfonate compound include an alkylsulfonate, for example, sodium n-butylsulfonate, sodium n-hexylsulfonate, sodium 2-ethylhexylsulfonate, sodium cyclohexylsulfonate or sodium n-octylsulfonate; an alkylsulfonate containing an ethylene oxide chain, for example, sodium 5,8,11-trioxapentadecane-1-sulfonate, sodium 5,8,11-trioxaheptadecane-1-sulfonate, sodium 13-ethyl-5,8,11-trioxaheptadecane-1-sulfonate or sodium 5,8,11,14-tetraoxatetracosane-1-sulfonate; an arylsulfonate, for example, sodium benzenesulfonate, sodium p-toluenesulfonate, sodium p-hydroxybenzenesulfonate, sodium p-styrenesulfonate, sodium isophthalic acid dimethyl-5-sulfonate, sodium 1-naphtylsulfonate, sodium 4-hydroxynaphtylsulfonate, disodium 1,5-naphtyldisulfonate or trisodium 1,3,6-naphtyltrisulfonate, and compounds described in Paragraph Nos. [0026] to [0031] of JP-A-2007-276454 and Paragraph Nos. [0020] to [0047] of JP-A-2009-154525. The salt may also be potassium salt or lithium salt.

The organic sulfate compound includes a sulfate of alkyl, alkenyl, alkynyl, aryl or heterocyclic monoether of polyethylene oxide. The number of unit of ethylene oxide is preferably from 1 to 4. The salt is preferably a sodium salt, a potassium salt or a lithium salt. Specific examples thereof include compounds described in Paragraph Nos. [0034] to [0038] of JP-A-2007-276454.

As the betaine compound, a compound wherein a number of carbon atoms included in a hydrocarbon substituent on the nitrogen atom is from 1 to 5 is preferable. Specific examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-porpanesulfonate and 3-(1-pyridinio)-1-porpanesulfonate.

Since the hydrophilic low molecular weight compound has a small structure of hydrophobic portion and almost no surface active function, degradations of the hydrophobicity and film strength in the image area due to penetration of dampening water into the exposed area (image area) of the image-recording layer are prevented and thus, the ink receptive-property and printing durability of the image-recording layer can be preferably maintained.

The amount of the hydrophilic low molecular weight compound added to the image-recording layer is preferably from 0.5 to 20% by weight, more preferably from 1 to 15% by weight, still more preferably from 2 to 10% by weight, based on the total solid content of the image-recording layer. In the range described above, good on-press development property and printing durability are obtained.

The hydrophilic low molecular weight compounds may be used individually or as a mixture of two or more thereof.

(4) Oil-sensitizing agent

In order to improve the ink-receptive property, an oil-sensitizing agent, for example, a phosphonium compound, a nitrogen-containing low molecular weight compound or an ammonium group-containing polymer can be used in the image-recording layer. In particular, in the case where an inorganic stratiform compound is incorporated into a protective layer, the oil-sensitizing agent functions as a surface covering agent of the inorganic stratiform compound and prevents deterioration of the ink-receptive property during printing due to the inorganic stratiform compound.

As preferable examples of the phosphonium compound, phosphonium compounds described in JP-A-2006-297907 and JP-A-2007-50660 are exemplified. Specific examples of the phosphonium compound include tetrabutylphosphonium iodide, butyltriphenylphosphonium bromide, tetraphenylphosphonium bromide, 1,4-bis(triphenylphosphonio)butane di(hexafluorophosphate), 1,7-bis(triphenylphosphonio)heptane sulfate and 1.9-bis(triphenylphosphonio)nonane naphthalene-2,7-disulfonate.

As the nitrogen-containing low molecular weight compound, an amine salt and a quaternary ammonium salt are exemplified. Also, an imidazolinium salt, a benzimidazolinium salt, a pyridinium salt and a quinolinium salt are exemplified. Of the nitrogen-containing low molecular weight compounds, the quaternary ammonium salt and pyridinium salt are preferably used. Specif examples the nitrogen-containing low molecular weight compound include tetramethylammonium hexafluorophosphate, tetrabutylammonium hexafluorophosphate, dodecyltrimethylammonium p-toluenesulfonate, benzyltriethylammonium hexafluorophosphate, benzyldimethyloctylammonium hexafluorophosphate, benzyldimethyldodecylammonium hexafluorophosphate and compounds described in Paragraph Nos. [0021] to [0037] of JP-A-2008-284858 and Paragraph Nos. [0030] to [0057] of JP-A-2009-90645.

The ammonium group-containing polymer may be any polymer containing an ammonium group in its structure and is preferably a polymer containing from 5 to 80% by mole of (meth)acrylate having an ammonium group in its side chain as a copolymerization component. Specific examples thereof include polymers described in Paragraph Nos. [0089]

to [0105] of JP-A-2009-208458.

As to the ammonium group-containing polymer, its reduced specific viscosity value (unit: ml/g) determined according to the measuring method described below is preferably from 5 to 120, more preferably from 10 to 110, particularly preferably from 15 to 100. When the reduced specific viscosity value described above is calculated in terms of weight average molecular weight (Mw), from 10,000 to 150,000 is preferred, from 17,000 to 140,000 is more preferred, and 20,000 to 130,000 is particularly preferred.

<Measuring method of reduced specific viscosity>

In a 20 ml measuring flask was weighed 3.33 g of a 30% by weight polymer solution (1 g as a solid content) and the measuring flask was filled up to the gauge line with N-methyl pyrrolidone. The resulting solution was allowed to stand in a thermostatic bath of 30°C for 30 minutes and put into an Ubbelohde viscometer (viscometer constant: 0.010 cSt/s) and a period for running down of the solution at 30°C was measured. The measurement was conducted twice for the same sample and an average value of the measurement was determined. The measurement was also conducted for a blank (only N-methyl pyrrolidone) in the same manner. The reduced specific viscosity was calculated according to the formula shown below.

$$\text{Reduced specific viscosity (ml/g)} = \frac{\dfrac{\text{Period for running down of sample solution (sec)} - \text{Period for running down of blank (sec)}}{\text{Period for running down of blank (sec)}}}{\dfrac{3.33\ (g) \times \dfrac{30}{100}}{20\ (ml)}}$$

Specific examples of the ammonium group-containing polymer are set forth below.

(1) 2-(Trimethylammonio)ethyl methacrylate p-toluenesulfonate/3,6-dioxaheptyl methacrylate copolymer (molar ratio: 10/90, Mw: 45,000)
(2) 2-(Trimethylammonio)ethyl methacrylate hexafluorophosphate /3,6-dioxaheptyl methacrylate copolymer (molar ratio: 20/80, Mw: 60,000)
(3) 2-(Ethyldimethylammonio)ethyl methacrylate p-toluenesulfonate/hexyl methacrylate copolymer (molar ratio: 30/70, Mw: 45,000)
(4) 2-(Trimethylammonio)ethyl methacrylate hexafluorophosphate /2-ethylhexyl methacrylate copolymer (molar ratio: 20/80, Mw: 60,000)
(5) 2-(Trimethylammonio)ethyl methacrylate methylsulfate/hexyl methacrylate copolymer (molar ratio: 40/60, Mw: 70,000)
(6) 2-(Butyldimethylammonio)ethyl methacrylate hexafluorophosphate/3,6-dioxaheptyl methacrylate copolymer (molar ratio: 25/75, Mw: 65,000)
(7) 2-(Butyldimethylammonio)ethyl acrylate hexafluorophosphate/3,6-dioxaheptyl methacrylate copolymer (molar ratio: 20/80, Mw: 65,000)
(8) 2-(Butyldimethylammonio)ethyl methacrylate 13-ethyl-5,8,11-trioxa-1-heptadecanesulfonate/3,6-dioxaheptyl methacrylate copolymer (molar ratio: 20/80, Mw: 75,000)
(9) 2-(Butyldimethylammonio)ethyl methacrylate hexafluorophosphate/3,6-dioxaheptyl methacrylate/2-hydroxy-3-methacryloyloxypropyl methacrylate copolymer (molar ratio: 15/80/5, Mw: 65,000)

The content of the oil-sensitizing agent is preferably from 0.01 to 30.0% by weight, more preferably from 0.1 to 15.0% by weight, still more preferably from 1 to 5% by weight, based on the total solid content of the image-recording layer.

(5) Others

Other components, for example, a surfactant, a coloring agent, a print-out agent, a polymerization inhibitor, a higher fatty acid derivative, a plasticizer, a fine inorganic particle, an inorganic stratiform compound, a co-sensitizer or a chain transfer agent may further be added to the image-recording layer. Specifically, compounds and amounts added

thereof described, for example, in Paragraph Nos. [0114] to [0159] of JP-A-2008-284817, Paragraph Nos. [0023] to [0027] of JP-A-2006-91479 and Paragraph No. [0060] of U.S. Patent Publication No. 2008/0311520 are preferably used.

(G) Formation of image-recording layer

The image-recording layer according to the invention is formed by dispersing or dissolving each of the necessary constituting components described above in a solvent to prepare a coating solution and coating the solution on a support by a known method, for example, bar coater coating and drying as described in Paragraph Nos. [0142] to [0143] of JP-A-2008-195018. The coating amount (solid content) of the image-recording layer formed on a support after coating and drying may be varied according to the intended purpose but is in general preferably from 0.3 to 3.0 g/$m^2$. In the range described above, good sensitivity and good film property of the image-recording layer can be obtained.

(Undercoat layer)

In the lithographic printing plate precursor according to the invention, an undercoat layer (also referred to as an intermediate layer) is preferably provided between the image-recording layer and the support. The undercoat layer strengthens adhesion between the support and the image-recording layer in the exposed area and makes removal of the image-recording layer from the support easy in the unexposed area, thereby contributing improvement in the developing property without accompanying degradation of the printing durability. Further, it is advantageous that in the case of infrared laser exposure, since the undercoat layer acts as a heat insulating layer, decrease in sensitivity due to diffusion of heat generated upon the exposure into the support is prevented.

As a compound for use in the undercoat layer, a compound having an adsorbing group capable of adsorbing to a surface of support and a crosslinkable group for improving an adhesion property to the image-recording layer is preferred. Further, a compound having a hydrophilicity-imparting group, for example, a sulfo group is also exemplified as a preferable compound. The compound may be a low molecular weight compound or a polymer compound. The compounds may be used in mixture of two or more thereof, if desired.

As the polymer compound, a copolymer of a monomer having an adsorbing group, a monomer having a hydrophilic group and a monomer having a crosslinkable group is preferred. As the adsorbing group capable of adsorbing to a surface of support, a phenolic hydroxy group, a carboxyl group, $-PO_3H_2$, $-OPO_3H_2$, $-CONHSO_2-$, $-SO_2NHSO_2-$ or $-COCH_2COCH_3$ is preferred. As the hydrophilic group, a sulfo group is preferred. As the crosslinkable group, for example, a methacryl group or an allyl group is preferred. The polymer compound may contain a crosslinkable group introduced by a salt formation between a polar substituent of the polymer compound and a compound containing a substituent having a counter charge to the polar substituent of the polymer compound and an ethylenically unsaturated bond and also may be further copolymerized with a monomer other than those described above, preferably a hydrophilic monomer.

Specifically, a silane coupling agent having an addition-polymerizable ethylenic double bond reactive group described in JP-A-10-282679 and a phosphorus compound having an ethylenic double bond reactive group described in JP-A-2-304441 are preferably exemplified. Low molecular weight compounds or polymer compounds having a crosslinkable group (preferably an ethylenically unsaturated bond group), a functional group capable of interacting with a surface of support and a hydrophilic group described in JP-A-2005-238816, JP-A-2005-125749, JP-A-2006-239867 and JP-A-2006-215263 are also preferably used.

Polymer compounds having an adsorbing group capable of adsorbing to a surface of support, a hydrophilic group and a crosslinkable group described in JP-A-2005-125749 and JP-A-2006-188038 are more preferred.

The content of the unsaturated double bond in the polymer compound for undercoat layer is preferably from 0.1 to 10.0 mmol, most preferably from 0.2 to 5.5 mmol, based on 1 g of the polymer compound.

Mw of the polymer compound for undercoat layer is preferably 5,000 or more, and more preferably from 10,000 to 300,000.

The undercoat layer according to the invention may contain a chelating agent, a secondary or tertiary amine, a polymerization inhibitor or a compound containing an amino group or a functional group having polymerization inhibition ability and a group capable of interacting with a surface of aluminum support (for example, 1,4-diazobicyclo[2,2,2]octane (DABCO), 2,3,5,6-tetrahydroxy-p-quinone, chloranil, sulfophthalic acid, hydroxyethylethylenediaminetriacetic acid, dihydroxyethylethylenediaminediacetic acid or hydroxyethyliminodiacetic acid) in addition to the compound for the undercoat layer described above in order to prevent the occurrence of stain due to preservation of the lithographic printing plate precursor.

The undercoat layer is coated according to a known method. The coating amount (solid content) of the undercoat layer is preferably from 0.1 to 100 mg/$m^2$, and more preferably from 1 to 30 mg/$m^2$.

(Support)

As the support for use in the lithographic printing plate precursor according to the invention, a known support is used. Particularly, an aluminum plate subjected to roughening treatment and anodizing treatment according to a known method is preferred.

Also, an enlarging treatment or a sealing treatment of micropores of the anodized film described in JP-A-2001-253181 and JP-A-2001-322365 or a surface hydrophilizing treatment, for example, with an alkali metal silicate as described in U.S. Patents 2,714,066, 3,181,461, 3,280,734 and 3,902,734 or polyvinyl phosphonic acid as described in U.S. Patents 3,276,868, 4,153,461 and 4,689,272 may be appropriately selected and applied to the aluminum plate, if desired.

The support preferably has a center line average roughness of 0.10 to 1.2 μm.

The support may have a backcoat layer containing an organic polymer compound described in JP-A-5-45885 or an alkoxy compound of silicon described in JP-A-5-45885, provided on the back surface thereof, if desired.

(Protective layer)

In the lithographic printing plate precursor according to the invention, it is preferred to provide a protective layer (overcoat layer) on the image-recording layer. The protective layer has a function for preventing, for example, occurrence of scratch in the image-recording layer or ablation caused by exposure with a high illuminance laser beam, in addition to the function for restraining an inhibition reaction against the image formation by means of oxygen blocking.

With respect to the protective layer having such properties, there are described, for example, in U.S. Patent 3,458,311 and JP-B-55-49729. As a polymer having low oxygen permeability for use in the protective layer, any water-soluble polymer and water-insoluble polymer can be appropriately selected to use. The polymers may be used in mixture of two or more thereof, if desired. Specifically, for example, polyvinyl alcohol, a modified polyvinyl alcohol, polyvinyl pyrrolidone, a water-soluble cellulose derivative and poly(meth)acrylonitrile are exemplified.

As the modified polyvinyl alcohol, an acid-modified polyvinyl alcohol having a carboxylic acid group or a sulfonic acid group is preferably used. Specifically, modified polyvinyl alcohols described in JP-A-2005-250216 and JP-A-2006-259137 are preferably exemplified.

It is also preferred for the protective layer to contain an inorganic stratiform compound, for example, natural mica or synthetic mica as described in JP-A-2005-119273 in order to increase the oxygen blocking property.

Further, the protective layer may contain a known additive, for example, a plasticizer for imparting flexibility, a surfactant for improving a coating property or a fine inorganic particle for controlling a surface slipping property. The oil-sensitizing agent described with respect to the image-recording layer may also be incorporated into the protective layer.

The protective layer is coated according to a known method. The coating amount of the protective layer is preferably in a range of 0.01 to 10 $g/m^2$, more preferably in a range of 0.02 to 3 $g/m^2$, most preferably in a range of 0.02 to 1 $g/m^2$, in terms of the coating amount after drying.

[Plate making method]

Plate making of the lithographic printing plate precursor according to the invention is preferably performed by an on-press development method. The on-press development method includes a step in which the lithographic printing plate precursor is imagewise exposed and a printing step in which oily ink and an aqueous component are supplied to the exposed lithographic printing plate precursor without undergoing any development processing to perform printing, and it is characterized in that the unexposed area of the lithographic printing plate precursor is removed in the course of the printing step. The imagewise exposure may be performed on a printing machine after the lithographic printing plate precursor is mounted on the printing machine or may be separately performed using a platesetter or the like. In the latter case, the exposed lithographic printing plate precursor is mounted as it is on a printing machine without undergoing a development processing step. Then, the printing operation is initiated using the printing machine with supplying oily ink and an aqueous component and at an early stage of the printing the on-press development is carried out. Specifically, the image-recording layer in the unexposed area is removed and the hydrophilic surface of support is revealed therewith to form the non-image area. As the oily ink and aqueous component, printing ink and dampening water for conventional lithographic printing can be employed, respectively.

The plate making method is described in more detail below.

As the light source used for the image exposure in the invention, a laser is preferable. The laser for use in the invention is not particularly restricted and preferably includes, for example, a solid laser or semiconductor laser emitting an infrared ray having a wavelength of 760 to 1,200 nm.

With respect to the infrared ray laser, the output is preferably 100 mW or more, the exposure time per pixel is preferably within 20 microseconds, and the irradiation energy is preferably from 10 to 300 $mJ/cm^2$. With respect to the

laser exposure, in order to shorten the exposure time, it is preferred to use a multibeam laser device.

The exposed lithographic printing plate precursor is mounted on a plate cylinder of a printing machine. In case of using a printing machine equipped with a laser exposure apparatus, the lithographic printing plate precursor is mounted on a plate cylinder of the printing machine and then subjected to the imagewise exposure.

When dampening water and/or printing ink are supplied to the imagewise exposed lithographic printing plate precursor to perform printing, in the exposed area of the image-recording layer, the image-recording layer cured by the exposure forms the printing ink receptive area having the oleophilic surface. On the other hand, in the unexposed area, the uncured image-recording layer is removed by dissolution or dispersion with the dampening water and/or printing ink supplied to reveal the hydrophilic surface in the area. As a result, the dampening water adheres onto the revealed hydrophilic surface and the printing ink adheres onto the exposed area of the image-recording layer, whereby printing is initiated.

While either the dampening water or printing ink may be supplied at first on the surface of lithographic printing plate precursor, it is preferred to supply the printing ink at first in view of preventing the dampening water from contamination with the component of the image-recording layer removed.

Thus, the lithographic printing plate precursor according to the invention is subjected to the on-press development on an offset printing machine and used as it is for printing a large number of sheets.

## EXAMPLES

The present invention will be described in more detail with reference to the following examples, but the invention should not be construed as being limited thereto. With respect to the polymer compounds used in the examples, a molecular weight means a weight average molecular weight (Mw) and a ratio of repeating unit is indicated in mole percent, unless otherwise particularly defined.

### I. Synthesis Example of Urethane Oligomer

#### Synthesis of Urethane oligomer 1

While mixing 10.71 g (0.025 mol) of C-1, 10.76 g (0.035 mol) of B-1 and 600 ml of methyl ethyl ketone at 45°C with stirring, 23.30 g (0.040 mol) of A-1 was dropwise added over a period of one hour, followed by reacting for 4 hours. After the reaction temperature was set at 10°C or below, 0.2 g of NEOSTAN U-600 (produced by Nitto Kasei Co., Ltd., bismuth catalyst) was dropwise added over a period of 30 minutes. The mixture was subjected to reacting at 45°C with stirring for 3 hours and then 50 g of ethanol was added thereto, followed by stirring for 10 minutes. Thereafter, the reaction mixture was precipitated with water, filtered and dried to synthesis Urethane oligomer 1. The Mw of the urethane oligomer was 3,000.

#### Synthesis of Urethane oligomer 5 (different in molecular weight)

While mixing 10.71 g (0.025 mol) of C-1, 10.76 g (0.035 mol) of B-1 and 400 ml of methyl ethyl ketone at 55°C with stirring, 23.30 g (0.040 mol) of A-1 was dropwise added over a period of one hour, followed by reacting for 4 hours. After the reaction temperature was set at 10°C or below, 0.2 g of NEOSTAN U-600 (produced by Nitto Kasei Co., Ltd., bismuth catalyst) was dropwise added over a period of 30 minutes. The mixture was subjected to reacting at 55°C with stirring for 3 hours and then 50 g of ethanol was added thereto, followed by stirring for 10 minutes. Thereafter, the reaction mixture was precipitated with water, filtered and dried to synthesis Urethane oligomer 5. The Mw of the urethane oligomer was 7,000.

#### Synthesis of Urethane oligomer 10 different in composition ratio)

While mixing 2.91 g (0.005 mol) of C-1, 23.67 g (0.055 mol) of B-1 and 600 ml of methyl ethyl ketone at 45°C with stirring, 23.30 g (0.040 mol) of A-1 was dropwise added over a period of one hour, followed by reacting for 4 hours. After the reaction temperature was set at 10°C or below, 0.2 g of NEOSTAN U-600 (produced by Nitto Kasei Co., Ltd., bismuth catalyst) was dropwise added over a period of 30 minutes. The mixture was subjected to reacting at 45°C with stirring for 3 hours and then 50 g of ethanol was added thereto, followed by stirring for 10 minutes. Thereafter, the reaction mixture was precipitated with water, filtered and dried to synthesis Urethane oligomer 10. The Mw of the urethane oligomer was 3,000.

Synthesis of other urethane oligomers

Other urethane oligomers were synthesized by appropriately applying the synthesis examples described above. The molecular weight was controlled by varying the reaction temperature, reaction time and the timing of addition of ethanol during the reaction.

II. Preparation Example of Aqueous Dispersion of Polymer particle

Preparation of Aqueous dispersion of polymer particle D1

A stirrer, a thermometer, a dropping funnel, a nitrogen inlet tube and a reflux condenser were attached to a 1,000 ml four-neck flask and while carrying out deoxygenation by introduction of nitrogen gas, 20 g of polyethylene glycol methyl ether methacrylate (PEGMA, average number of ethylene glycol repeating units: 4), 200 g of distilled water and 200 g of n-propanol were charged therein and heated until the internal temperature reached 70°C. Then, a mixture of 30 g of styrene (St), 50 g of acrylonitrile (AN) and 0.8 g of 2,2'-azobisisobutyronitrile previously prepared was dropwise added to the flask over a period of one hour. After the completion of the dropwise addition, the reaction was continued as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6 hours. At the stage after reacting for 20 hours in total, the polymerization proceeded 98% or more to obtain Aqueous dispersion of polymer particle D1 of PEGMA/St/AN (20/30/50 in a weight ratio). The particle size distribution of the polymer particle had the maximum value at the particle size of 150 nm.

Preparation of Aqueous dispersion of polymer particle D2

An oil phase component was prepared by dissolving 4.46 g of polyfunctional isocyanate having the structure shown below (produced by Mitsui Chemicals Polyurethanes. Inc., 75% ethyl acetate solution), 0.86 g of adduct obtained by addition of trimethylol propane (6 mol) and xylene diisocyanate (18 mol) and further addition of methyl-terminated polyoxyethylene (1 mol) (number of oxyethylene repeating unit: 90) (produced by Mitsui Chemicals Polyurethanes, Inc., 50% ethyl acetate solution), 1.72 g of pentaerythritol tetraacrylate (SR399E, produced by Sartomer Co., Inc.) and 0.05 g of PIONIN A-41C (produced by Takemoto Oil & Fat Co., Ltd., 70% methanol solution) in 4.46 g of ethyl acetate. The oil phase component was mixed with 17.30 g of water as an aqueous phase component and emulsified using a homogenizer at 10,000 rpm for 15 minutes. The resulting emulsion was stirred at 40°C for 4 hours. The poly(polyurea/urethane) fine particle (microgel) liquid thus-obtained was diluted using water so as to have the solid content concentration of 15% by weight to prepare polyurea/urethane fine particle (microgel) liquid, which was designated as Aqueous dispersion of polymer particle D2. The average particle size of the polyurea/urethane fine particle (microgel) was measured by a light scattering method and found to be 0.25 μm.

Polyfunctional isocyanate:

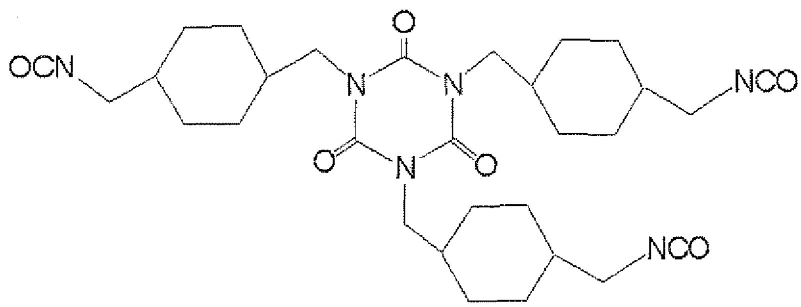

Preparation of Aqueous dispersion of polymer particle (polyurea/urethane fine particle having urethane oligomer incorporated) D3)

An oil phase component was prepared by dissolving 10 g of adduct of trimethylol propane and xylene diisocyanate (TAKENATE D-110N, produced by Mitsui Chemicals Polyurethanes, Inc.), 3.15 g of pentaerythritol triacrylate (SR444, produced by Nippon Kayaku Co., Ltd.), 0.1 g of PIONIN A-41C (produced by Takemoto Oil & Fat Co., Ltd.) and

0.5 g of Urethane oligomer 1 in 17 g of ethyl acetate. As an aqueous phase component, 40 g of a 4% by weight aqueous solution of PVA-205 was prepared. The oil phase component and the aqueous phase component were mixed and emulsified using a homogenizer at 12,000 rpm for 10 minutes. The resulting emulsion was added to 25 g of distilled water and stirred at room temperature for 30 minutes and then at 50°C for 3 hours. The polyurea/urethane fine particle (microgel) liquid thus-obtained was diluted using distilled water so as to have the solid concentration of 15% by weight to prepare Aqueous dispersion of polymer particle D3. The average particle size of the polyurea/urethane fine particle (microgel) was measured by a light scattering method and found to be 0.2 μm.

Preparation of Aqueous dispersion of Polymer article D4

A stirrer, a thermometer, a dropping funnel, a nitrogen inlet tube and a reflux condenser were attached to a 1,000 ml four-neck flask and while carrying out deoxygenation by introduction of nitrogen gas, 20 g of ethylene glycol, 200 g of distilled water and 200 g of n-propanol were charged therein and heated until the internal temperature reached 70°C. Then, a mixture of 20 g of styrene (St), 80 g of acrylonitrile (AN) and 0.8 g of 2,2'-azobisisobutyronitrile previously prepared was dropwise added to the flask over a period of one hour. After the completion of the dropwise addition, the reaction was continued as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6 hours. At the stage after reacting for 20 hours in total, the polymerization proceeded 98% or more to obtain Aqueous dispersion of polymer particle D4 of St/AN (20/80 in a weight ratio). The particle size distribution of the polymer particle had the maximum value at the particle size of 170 nm.

Preparation of Aqueous dispersion of polymer particle D5

A stirrer, a thermometer, a dropping funnel, a nitrogen inlet tube and a reflux condenser were attached to a 1,000 ml four-neck flask and while carrying out deoxygenation by introduction of nitrogen gas, 350 ml of distilled water was charged therein and heated until the internal temperature reached 80°C. Then, 1.5 g of sodium dodecylsulfate was added as a dispersing agent, then 0.45 g of ammonium persulfate was added as an initiator and thereafter 45.0 g of styrene was dropwise added through the dropping funnel over a period of about one hour. After the completion of the dropwise addition, the reaction was continued as it was for 5 hours. Then, the unreacted monomer was removed by steam distillation. The reaction solution was cooled and adjusted its pH to 6 with aqueous ammonia, and finally water was added thereto so as to have the solid concentration of 15% by weight to prepare Aqueous dispersion of polymer particle D5. The particle size distribution of the polymer particle measured in the same manner as in Aqueous dispersion of polymer particle D1 had the maximum value at the particle size of 60 nm.

Preparation of Aqueous dispersion of polymer article D6

A stirrer, a thermometer, a dropping funnel, a nitrogen inlet tube and a reflux condenser were attached to a 1,000 ml four-neck flask and while carrying out deoxygenation by introduction of nitrogen gas, 20 g of polyethylene glycol methyl ether methacrylate (PEGMA, average number of ethylene glycol repeating units: 2), 200 g of distilled water and 200 g of n-propanol were charged therein and heated until the internal temperature reached 70°C. Then, a mixture of 10 g of styrene (St), 50 g of acrylonitrile (AN), 20 g of allyl methacrylate (AllylMA) and 0.8 g of 2,2'-azobisisobutyronitrile previously prepared was dropwise added to the flask over a period of one hour. After the completion of the dropwise addition, the reaction was continued as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6 hours. At the stage after reacting for 20 hours in total, the polymerization proceeded 98% or more to obtain Aqueous dispersion of polymer particle D6 of EGMA/St/AN/AllylMA (20/10/50/20 in a weight ratio). The particle size distribution of the polymer particle had the maximum value at the particle size of 150 nm.

Preparation or Aqueous dispersion of polymer particle D7

A stirrer, a thermometer, a dropping funnel, a nitrogen inlet tube and a reflux condenser were attached to a 1,000 ml four-neck flask and while carrying out deoxygenation by introduction of nitrogen gas, 20 g of polyethylene glycol methyl ether methacrylate (PEGMA, average number of ethylene glycol repeating units: 4), 200 g of distilled water and 200 g of n-propanol were charged therein and heated until the internal temperature reached 70°C. Then, a mixture of 10 g of styrene (St), 50 g of acrylonitrile (AN), 20 g of allyl methacrylate (AllylMA) and 0.8 g of 2,2'-azobisisobutyronitrile previously prepared was dropwise added to the flask over a period of one hour. After the completion of the dropwise addition, the reaction was continued as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6

hours. At the stage after reacting for 20 hours in total, the polymerization proceeded 98% or more to obtain Aqueous dispersion of polymer particle D7 of PEGMA/St/AN/AllylMA (20/10/50/20 in a weight ratio). The particle size distribution of the polymer particle had the maximum value at the particle size of 150 nm.

Preparation of Aqueous dispersion of polymer particle D8

A stirrer, a thermometer, a dropping funnel, a nitrogen inlet tube and a reflux condenser were attached to a 1,000 ml four-neck flask and while carrying out deoxygenation by introduction of nitrogen gas, 20 g of polyethylene glycol methyl ether methacrylate (PEGMA, average number of ethylene glycol repeating units: 20), 200 g of distilled water and 200 g of n-propanol were charged therein and heated until the internal temperature reached 70°C. Then, a mixture of 10 g of styrene (St), 50 g of acrylonitrile (AN), 20 g of allyl methacrylate (AllylMA) and 0.8 g of 2,2'-azobisisobutyronitrile previously prepared was dropwise added to the flask over a period of one hour. After the completion of the dropwise addition, the reaction was continued as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6 hours. At the stage after reacting for 20 hours in total, the polymerization proceeded 98% or more to obtain Aqueous dispersion of polymer particle D8 of PEGMA/St/AN/AllylMA (20/10/50/20 in a weight ratio). The particle size distribution of the polymer particle had the maximum value at the particle size of 150 nm.

Preparation of Aqueous dispersion of polymer particle D9

A stirrer, a thermometer, a dropping funnel, a nitrogen inlet tube and a reflux condenser were attached to a 1,000 ml four-neck flask and while carrying out deoxygenation by introduction of nitrogen gas, 20 g of polyethylene glycol methyl ether methacrylate (PEGMA, average number of ethylene glycol repeating units: 45), 200 g of distilled water and 200 g of n-propanol were charged therein and heated until the internal temperature reached 70°C. Then, a mixture of 10 g of styrene (St), 50 g of acrylonitrile (AN), 20 g of allyl methacrylate (AllylMA) and 0.8 g of 2,2'-azobisisobutyronitrile previously prepared was dropwise added to the flask over a period of one hour. After the completion of the dropwise addition, the reaction was continued as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6 hours. At the stage after reacting for 20 hours in total, the polymerization proceeded 98% or more to obtain Aqueous dispersion of polymer particle D9 of PEGMA/St/AN/AllylMA (20/10/50/20 in a weight ratio). The particle size distribution of the polymer particle had the maximum value at the particle size of 150 nm.

Preparation of Aqueous dispersion of polymer article D10

A stirrer, a thermometer, a dropping funnel, a nitrogen inlet tube and a reflux condenser were attached to a 1,000 ml four-neck flask and while carrying out deoxygenation by introduction of nitrogen gas, 20 g of polyethylene glycol methyl ether methacrylate (PEGMA, average number of ethylene glycol repeating units: 1), 200 g of distilled water and 200 g of n-propanol were charged therein and heated until the internal temperature reached 70°C. Then, a mixture of 10 g of styrene (St), 50 g of acrylonitrile (AN), 20 g of allyl methacrylate (AllylMA) and 0.8 g of 2,2'-azobisisobutyronitrile previously prepared was dropwise added to the flask over a period of one hour. After the completion of the dropwise addition, the reaction was continued as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6 hours. At the stage after reacting for 20 hours in total, the polymerization proceeded 98% or more to obtain Aqueous dispersion of polymer particle D10 of PEGMA/St/AN/AllylMA (20/10/50/20 in a weight ratio). The particle size distribution of the polymer particle had the maximum value at the particle size of 150 nm.

The particle size distribution was determined by taking an electron microphotograph of the polymer particle, measuring particle sizes of 5,000 fine particles in total on the photograph, and dividing a range from the largest value of the particle size measured to 0 on a logarithmic scale into 50 parts to obtain occurrence frequency of each particle size by plotting. With respect to the aspherical particle, a particle size of a spherical particle having a particle area equivalent to the particle area of the aspherical particle on the photograph was defined as the particle size.

The polymer particles of the preparation examples described above are simply indicated below.

D1: Poly[PEGMA (number of ethylene oxide repeating units: 4)/St/AN] fine particle
D2: Polyurea/urethane fine particle
D3: Polyurea/urethane fine particle (having urethane oligomer incorporated) for Comparative Example
D4: Poly[St/AN] fine particle (containing no polyoxyalkylene group)
D5:Poly[St] fine particle
D6: Poly[PEGMA (number of ethylene oxide repeating units: 2)/St/AN/AllylMA] fine particle

D7: Poly[PEGMA (number of ethylene oxide repeating units: 4)/St/AN/AllylMA] fine particle
D8: Poly[PEGMA (number of ethylene oxide repeating units: 20)/St/AN/AllylMA] fine particle
D9: Poly[PEGMA (number of ethylene oxide repeating units: 45)/St/AN/AllylMA] fine particle
D10: Poly[PEGMA (number of ethylene oxide repeating units: 1)/St/AN/AllylMA] fine particle

Examples 1 to 5 and 18 to 53 and Comparative Examples 3 and 4

1. Preparation of Lithographic printing plate precursor

(1) Preparation of Support

An aluminum plate (material: JIS A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/$cm^3$) of pumice having a median size of 25 μm, followed by thorough washing with water. The plate was subjected to etching by immersing in a 25% by weight aqueous sodium hydroxide solution of 45°C for 9 seconds, washed with water, then immersed in a 20% by weight aqueous nitric acid solution at 60°C for 20 seconds, and washed with water. The etching amount of the grained surface was about 3 g/$m^2$.

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50°C. The electrochemical roughening treatment was conducted using an alternating current source, which provides a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/$dm^2$ in terms of the peak value of the electric current, and 5% of the electric current flowing from the electric source was divided to the auxiliary anode. The quantity of electricity in the nitric acid electrolysis was 175 C/$dm^2$ in terms of the quantity of electricity when the aluminum plate functioned as an anode. The plate was then washed with water by spraying.

The plate was further subjected to an electrochemical roughening treatment in the same manner as in the nitric acid electrolysis above using as an electrolytic solution, a 0.5% by weight aqueous hydrochloric acid solution (containing 0.5% by weight of aluminum ion) having temperature of 50°C and under the condition that the quantity of electricity was 50 C/$dm^2$ in terms of the quantity of electricity when the aluminum plate functioned as an anode. The plate was then washed with water by spraying.

The plate was then subjected to an anodizing treatment using as an electrolytic solution, a 15% by weight aqueous sulfuric acid solution (containing 0.5% by weight of aluminum ion) at a current density of 15 A/$dm^2$ to form a direct current anodized film of 2.5 g/$m^2$, washed with water and dried to prepare Support (1).

Thereafter, in order to ensure the hydrophilicity of the non-image area, Support (1) was subjected to silicate treatment using a 2.5% by weight aqueous sodium silicate No. 3 solution at 60°C for 10 seconds and then washed with water to obtain Support (2). The adhesion amount of Si was 10 mg/$m^2$. The center line average roughness (Ra) of the support was measured using a stylus having a diameter of 2 μm and found to be 0.51 μm.

(2) Formation of Undercoat layer

Coating solution (1) for undercoat layer shown below was coated on Support (2) so as to have a dry coating amount of 20 mg/$m^2$ to prepare a support having an undercoat layer.

<Coating solution (1) for undercoat layer>

| | |
|---|---|
| Compound (1) for undercoat layer having structure shown below | 0.18 g |
| Hydroxyethyliminodiacetic acid | 0.10 g |
| Methanol | 55.24 g |
| Water | 6.15 g |

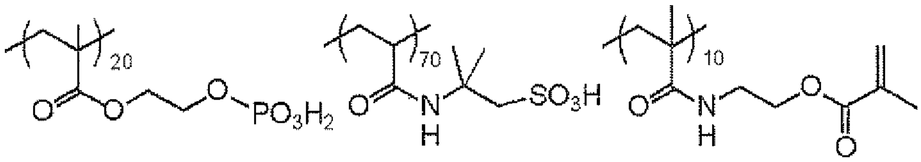

(Mw: 100,000)

Compound (1) for undercoat layer

Coating solution (1) for image-recording layer shown below was coated on the support provided with the undercoat layer described above by a bar and dried in an oven at 70°C for 60 seconds to form an image-recording layer having a dry coating amount of 0.6 g/$m^2$, thereby preparing lithographic printing plate precursors for Examples 1 to 5 and 18 to 53 and Comparative Examples 3 and 4, respectively.

<Coating solution (1) for image-recording layer>

| | |
|---|---|
| Aqueous dispersion of polymer particle shown in Table below | 20.0 g |
| Infrared absorbing agent (1) having structure shown below | 0.2 g |
| Radical polymerization initiator (IRGACURE 250, produced by Ciba Specialty Chemicals, Inc.) | 0.5 g |
| Radical polymerizable urethane oligomer shown in Table below | 0.24 g |
| Mercapto-3-triazole | 0.2 g |
| BYK 336 (produced by BYK-Chemie GmbH) | 0.4 g |
| KLUCEL M (produced by Hercules Chemical Co., Inc.) | 4.8 g |
| ELVACITE 4026 (produced by Ineos Acrylics Inc.) | 2.5 g |
| n-Propanol | 55.0 g |
| 2-Butanone | 17.0 g |

The compounds indicated using their trade names in the composition above are shown below.
IRGACURE 250: (4-Methoxyphenyl)[4-(2-methylpropyl)phenyl]iodonium hexafluorophosphate (75% by weight propylene carbonate solution)
BYK 336: Modified dimethylpolysiloxane copolymer (25% by weight xylene/methoxypropyl acetate solution)
KLUCEL M: Hydroxypropyl cellulose (2% by weight aqueous solution)
ELVACITE 4026: Highly branched polymethyl methacrylate (10% by weight 2-butanone solution)

Infrared absorbing agent (1):

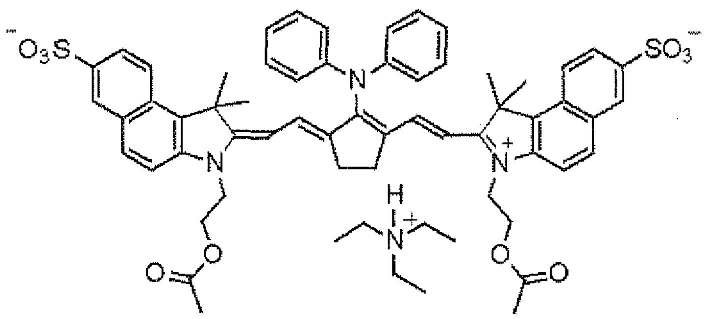

Example 6

Using Aqueous dispersion of polymer particle D2 in place of Aqueous dispersion of polymer particle D1 in Coating solution (1) for image-recording layer used in the lithographic printing plate precursor for Example 1, an image-recording layer was prepared. Coating solution (1) for protective layer having the composition shown below was coated on the image-recording layer by a bar and dried in an oven at 120°C for 60 seconds to form a protective layer having a dry coating amount of 0.15 g/$m^2$, thereby preparing a lithographic printing plate precursor for Example 6.

Example 7

Coating solution (1) for protective layer having the composition shown below was coated on the image-recording layer of the lithographic printing plate precursor for Example 1 by a bar and dried in an oven at 120°C for 60 seconds to form a protective layer having a dry coating amount of 0.15 g/$m^2$, thereby preparing a lithographic printing plate precursor for Example 7.

<Coating solution (1) for protective layer>

| | |
|---|---|
| Dispersion of inorganic stratiform compound (1) shown below | 1.5 g |
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5 % by mole, polymerization degree: 500, produced by Kuraray Co., Ltd.) | 0.03 g |
| Aqueous 1% by weight solution of surfactant (EMALEX 710, produced by Nihon Emulsion Co., Ltd.) | 0.86 g |
| Ion-exchanged water | 6.0 g |

(Preparation of Dispersion of inorganic stratiform compound (1))

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 μm to prepare Dispersion of inorganic stratiform compound (1). The aspect ratio of the inorganic particle thus-dispersed was 100 or more.

Example 8

A lithographic printing plate precursor for Example 8 was prepared in the same manner as in Example 1 except for further adding 0.2 g of binder polymer [Specific example (10) of binder polymer described hereinbefore, Mw: 25000] to Coating solution (1) for image-recording layer.

Example 9

A lithographic printing plate precursor for Example 9 was prepared in the same manner as in Example 1 except for further adding 0.3 g of polymerizable compound (tetraethylene glycol dimethacrylate) to Coating solution (1) for image-recording layer.

Example 10

Using the polymer particle shown in Table 2 below in place of Aqueous dispersion of polymer particle D1 in Coating solution (1) for image-recording layer used in the lithographic printing plate precursor for Example 1, an image-recording layer was prepared, thereby preparing a lithographic printing plate precursor for Example 10.

Examples 11 to 17

Using the polymer particle shown in Table 3 below in place of Aqueous dispersion of polymer particle D1 in Coating solution (1) for image-recording layer used in the lithographic printing plate precursor for Example 1, lithographic

printing plate precursors for Examples 11 to 17 were prepared, respectively.

Comparative Example 1

A lithographic printing plate precursor for Comparative Example 1 was prepared in the same manner as in Example 1 except for changing the radical polymerizable urethane oligomer in Coating solution (1) for image-recording layer to Urethane Oligomer UA-306H (pentaerythritol triacrylate/hexamethylene diisocyanate urethane prepolymer (Mw: 726), produced by Kyoeisha Chemical Co., Ltd.).

Comparative Example 2

The coating solution for image-recording layer prepared by eliminating Urethane oligomer 1 from Coating solution (1) for image-recording layer and using Polymer particle D3 having Urethane oligomer 1 incorporated in place of Aqueous dispersion of polymer particle D1 was coated in the same manner as in Example 1 to form an image-recording layer. Coating solution (1) for protective layer shown above was coated on the image-recording layer by a bar and dried in an oven at 120°C for 60 seconds to form a protective layer having a dry coating amount of 0.15 g/$m^2$, thereby preparing a lithographic printing plate precursor for Comparative Example 2.

Comparative Example 5

A lithographic printing plate precursor for Comparative Example 5 was prepared in the same manner as in Example 1 except for eliminating Aqueous dispersion of polymer particle D1 in Coating solution (1) for image-recording layer.

Comparative Example 6

A lithographic printing plate precursor for Comparative Example 6 was prepared in the same manner as in Example 1 except for changing the radical polymerizable urethane oligomer in Coating solution (1) for image-recording layer to Radical polymerizable urethane oligomer X1 not containing C component shown in Table 4 below.

Comparative Example 7

A lithographic printing plate precursor for Comparative Example 7 was prepared in the same manner as in Example 1 except for changing the radical polymerizable urethane oligomer in Coating solution (1) for image-recording layer to Radical polymerizable urethane oligomer X2 not containing B component shown in Table 4 below.

[Evaluation of Lithographic printing plate precursor]

(1) Printing durability

Each of the lithographic printing plate precursors thus-obtained was exposed by LUXEL PLATESETTER T-6000III equipped with an infrared semiconductor laser (produced by FUJIFILM Corp.) under the conditions of a rotational number of an external drum of 1,000 rpm, laser output of 70% and resolution of 2,400 dpi. The exposed image contained a solid image and a 50% halftone dot chart of a 20 μm-dot FM screen.

The exposed lithographic printing plate precursor was mounted without undergoing development processing on a plate cylinder of a printing machine (LITHRONE 26, produced by Komori Corp.). Using dampening water (ECOLITY-2 (produced by FUJIFILM Corp.)/tap water = 2/98 (volume ratio)) and VALUES-G (N) Black Ink (produced by Dainippon Ink & Chemicals, Inc.), the dampening water and ink were supplied according to the standard automatic printing start method of LITHRONE 26 to conduct printing on TOKUBISHI ART PAPER (76.5 kg) at a printing speed of 10,000 sheets per hour.

As the increase in a number of printing papers, the image-recording layer was gradually abraded to cause decrease in the ink density on the printing paper. A number of the printing papers wherein a value obtained by measuring a halftone dot area rate of the 50% halftone dot of FM screen on the printing paper using a Gretag densitometer decreased by 5% from the value measured on the $100^{th}$ paper of the printing was determined to evaluate the printing durability. The results obtained are shown in the tables below.

(2) Printing stain

The lithographic printing plate was subjected to the printing in the manner described above and after printing 10,000 sheets, the stain on a blanket corresponding to the non-image area was transferred to a tape and evaluated on a scale of ten levels as shown below.

100: Ink stain area per $cm^2$ of tape was less than 1%.
90: Ink stain area per $cm^2$ of tape was less than 2%.
80: Ink stain area per $cm^2$ of tape was less than 4%.
70: Ink stain area per $cm^2$ of tape was less than 6%.
60: Ink stain area per $cm^2$ of tape was less than 8%.
50: Ink stain area per $cm^2$ of tape was less than 10%.
40: Ink stain area per $cm^2$ of tape was less than 15%.
30: Ink stain area per $cm^2$ of tape was less than 20%.
20: Ink stain area per $cm^2$ of tape was less than 30%.
10: Ink stain area per $cm^2$ of tape was less than 40%.
0: Ink stain area per $cm^2$ of tape was 40% or more.

The results obtained are shown in the tables below.

(3) On-press development scum

The lithographic printing plate was subjected to the printing under the condition described above and after printing 10,000 sheets, the on-press development scum on the non-image area was visually evaluated. Specifically, after printing 10,000 sheets, the scum on the water supplying roller was transferred to a tape and observed using a microscope to evaluate on a scale of ten levels as shown below.

100: Number of scum having a length of 3 micrometers or longer per $cm^2$ of tape was less than 2.
90: Number of scum having a length of 3 micrometers or longer per $cm^2$ of tape was less than 4.
80: Number of scum having a length of 3 micrometers or longer per $cm^2$ of tape was less than 6.
70: Number of scum having a length of 3 micrometers or longer per $cm^2$ of tape was less than 10.
60: Number of scum having a length of 3 micrometers or longer per $cm^2$ of tape was less than 15.
50: Number of scum having a length of 3 micrometers or longer per $cm^2$ of tape was less than 20.
40: Number of scum having a length of 3 micrometers or longer per $cm^2$ of tape was less than 25.
30: Number of scum having a length of 3 micrometers or longer per $cm^2$ of tape was less than 30.
20: Number of scum having a length of 3 micrometers or longer per $cm^2$ of tape was less than 40.
10: Number of scum having a length of 3 micrometers or longer per $cm^2$ of tape was less than 50.
0: Number of scum having a length of 3 micrometers or longer per $cm^2$ of tape was 50 or more.

The results obtained are shown in the tables below.

TABLE 1: Examples 1 to 5, 8, 9 and 53 and Comparative Examples 1 to 4

| | Urethane Oligomer | | | | | | | | Polymer particle | Evaluation Result | | |
|---|---|---|---|---|---|---|---|---|---|---|---|---|
| | No. | Kind and Content (% by mol) of Raw Material Component for Synthesis | | | | | | Mw | | Printing Durability (x $10^4$ sheets) | On-Press Development Scum | Printing Stain |
| | | A Component | | B Component | | C Component | | | | | | |
| Example 1 | 1 | A-1 | 40 | B-1 | 35 | C-1 | 25 | 3,000 | D1 | 7.0 | 100 | 90 |
| Example 2 | 2 | A-1 | 40 | B-1 | 35 | C-1 | 25 | 5,000 | D1 | 7.0 | 100 | 90 |
| Example 3 | 3 | A-1 | 40 | B-1 | 35 | C-1 | 25 | 2,000 | D1 | 7.0 | 100 | 90 |
| Example 4 | 4 | A-1 | 40 | B-1 | 35 | C-1 | 25 | 1,500 | D1 | 6.0 | 100 | 90 |
| Example 5 | 5 | A-1 | 40 | B-1 | 35 | C-1 | 25 | 7,000 | D1 | 7.0 | 90 | 80 |
| Example 8 (*1) | 1 | A-1 | 40 | B-1 | 35 | C-1 | 25 | 3,000 | D1 | 8.0 | 80 | 80 |
| Example 9 (*2) | 1 | A-1 | 40 | B-1 | 35 | C-1 | 25 | 3,000 | D1 | 8.0 | 80 | 80 |
| Example 53 | 6 | A-1 | 40 | B-1 | 35 | C-1 | 25 | 10,000 | D1 | 7.0 | 80 | 80 |
| Comparative Example 1 | Urethane Oligomer UA-306H (*3) | | | | | | | 726 | D1 | 2.0 | 40 | 30 |
| Comparative Example 2 | None (*4) | | | | | | | | D3 | 3.0 | 10 | 10 |
| Comparative Example 3 | 7 | A-1 | 40 | B-1 | 35 | C-1 | 25 | 1,000 | D1 | 1.0 | 100 | 90 |
| Comparative Example 4 | 8 | A-1 | 40 | B-1 | 35 | C-1 | 25 | 15,000 | D1 | 7.0 | 0 | 10 |

(*1) Containing binder polymer
(*2) Containing polymerizable compound other than urethane oligomer
(*3) Pentaerythritol triacrylate/hexamethylene diisocyanate urethane prepolymer (produced by Kyoeisha Chemical Co., Ltd., UA-306H)
(*4) Polymer particle D3 having Urethane oligomer 1 incorporated

From the results shown in Table 1 it can be seen that the lithographic printing plate precursor which exhibits not only high printing durability, but also less on-press development scum and good printing stain can be obtained in the case of using the radical polymerizable urethane oligomer according to the invention.

The radical polymerizable urethane oligomer according to the invention is excellent in any of the printing durability, on-press development scum and printing stain in comparison with the case of using a known urethane oligomer in Comparative Example 1.

Comparative Example 2 indicates that the case where although the radical polymerizable urethane oligomer according to the invention is contained, it is incorporated into the polymer particle and is not present outside of the polymer particle does not achieve the effects of the invention.

Further, Comparative Examples 3 and 4 indicate that the case where the Mw of the radical polymerizable urethane oligomer is outside of the range according to the invention, the effects of the invention that all of the printing durability, on-press development scum and printing stain are good are not achieved.

TABLE 2: Case Having Protective Layer (Examples 6 and 7)

| | Urethane Oligomer | | | | | | | | Polymer particle | Evaluation Result | | |
|---|---|---|---|---|---|---|---|---|---|---|---|---|
| | No. | Kind and Content (% by mol) of Raw Material Component for Synthesis | | | | | | Mw | | Printing Durability (x $10^4$ sheets) | On-Press Development Scum | Printing Stain |
| | | A Component | | B Component | | C Component | | | | | | |
| Example 1 | 1 | A-1 | 40 | B-1 | 35 | C-1 | 25 | 3,000 | D1 | 7.0 | 100 | 90 |
| Example 7* | 1 | A-1 | 40 | B-1 | 35 | C-1 | 25 | 3,000 | D1 | 8.0 | 80 | 80 |
| Example 10 | 1 | A-1 | 40 | B-1 | 35 | C-1 | 25 | 3,000 | D2 | 6.5 | 90 | 90 |
| Example 6* | 1 | A-1 | 40 | B-1 | 35 | C-1 | 25 | 3,000 | D2 | 7.0 | 80 | 80 |

* Having protective layer

The effects of the invention are also achieved in the case of providing a protective layer (Examples 7 and 6) and the printing durability is more improved in comparison with the case where the protective layer is not provided (Examples 1 and 10).

TABLE 3: Variety of Polymer particles (Examples 1 and 10 to 17)

| | Urethane Oligomer | | | | | | | | Polymer particle | Evaluation Result | | |
|---|---|---|---|---|---|---|---|---|---|---|---|---|
| | No. | Kind and Content (% by mol) of Raw Material Component for Synthesis | | | | | | Mw | | Printing Durability (x $10^4$ sheets) | On-Press Development Scum | Printing Stain |
| | | A Component | | B Component | | C Component | | | | | | |
| Example 1 | 1 | A-1 | 40 | B-1 | 35 | C-1 | 25 | 3,000 | D1 | 7.0 | 100 | 90 |
| Example 10 | 1 | A-1 | 40 | B-1 | 35 | C-1 | 25 | 3,000 | D2 | 6.5 | 90 | 90 |
| Example 11 | 1 | A-1 | 40 | B-1 | 35 | C-1 | 25 | 3,000 | D4 | 7.0 | 80 | 70 |
| Example 12 | 1 | A-1 | 40 | B-1 | 35 | C-1 | 25 | 3,000 | D5 | 6.0 | 80 | 70 |
| Example 13 | 1 | A-1 | 40 | B-1 | 35 | C-1 | 25 | 3,000 | D6 | 8.0 | 100 | 90 |
| Example 14 | 1 | A-1 | 40 | B-1 | 35 | C-1 | 25 | 3,000 | D7 | 8.0 | 100 | 90 |
| Example 15 | 1 | A-1 | 40 | B-1 | 35 | C-1 | 25 | 3,000 | D8 | 8.0 | 100 | 90 |
| Example 16 | 1 | A-1 | 40 | B-1 | 35 | C-1 | 25 | 3,000 | D9 | 7.5 | 100 | 90 |
| Example 17 | 1 | A-1 | 40 | B-1 | 35 | C-1 | 25 | 3,000 | D10 | 6.5 | 80 | 70 |
| Comparative Example 5 | 1 | A-1 | 40 | B-1 | 35 | C-1 | 25 | 3,000 | - | 4.0 | 0 | 20 |

From the results shown in Table 3 it can be seen that when the polymer particle is not contained as in Comparative Example 5, the deterioration of on-press development scum and printing stain is particularly notable.

In the examples of the invention, although any of Polymer particles D1 to D10 exhibits the effects of the invention, in particular, the cases where the polymer particle having a polyoxyalkylene group is contained (Examples 1, 10 and 13 to 16) are excellent in view of the on-press development scum and printing stain. It is also understood from the comparison of Examples 13 to 17 that the number of ethylene oxide repeating unit included in the polymer particle is particularly preferably from 2 to 20.

Further, it is apparent that the polymer particle containing a cyano group is more preferred from the standpoint of the printing durability.

TABLE 4: Urethane Oligomer of Variety of Composition Rates (Examples 1 and 18 to 23 and Comparative Examples 6 and 7)

| | Urethane Oligomer | | | | | | | | Polymer particle | Evaluation Result | | |
|---|---|---|---|---|---|---|---|---|---|---|---|---|
| | No. | Kind and Content (% by mol) of Raw Material Component for Synthesis | | | | | | Mw | | Printing Durability (x $10^4$ sheets) | On-Press Development Scum | Printing Stain |
| | | A Component | | B Component | | C Component | | | | | | |
| Example 1 | 1 | A-1 | 40 | B-1 | 35 | C-1 | 25 | 3,000 | D1 | 7.0 | 100 | 90 |
| Example 18 | 9 | A-1 | 40 | B-1 | 25 | C-1 | 35 | 3,000 | D1 | 7.0 | 100 | 100 |
| Example 19 | 10 | A-1 | 40 | B-1 | 55 | C-1 | 5 | 3,000 | D1 | 7.5 | 60 | 70 |
| Example 20 | 11 | A-1 | 40 | B-1 | 10 | C-1 | 50 | 3,000 | D1 | 6.0 | 100 | 100 |
| Example 21 | 12 | A-1 | 10 | B-1 | 50 | C-1 | 40 | 3,000 | D1 | 6.0 | 100 | 100 |
| Example 22 | 13 | A-1 | 25 | B-1 | 50 | C-1 | 25 | 3,000 | D1 | 7.5 | 90 | 90 |
| Example 23 | 14 | A-1 | 70 | B-1 | 5 | C-1 | 25 | 3,000 | D1 | 6.0 | 70 | 60 |
| Comparative Example 6 | X1 | A-1 | 40 | B-1 | 60 | - | - | 3,000 | D1 | 4.0 | 20 | 20 |
| Comparative Example 7 | X2 | A-1 | 40 | - | - | C-8 | 60 | 3,000 | D1 | 0.5 | 100 | 100 |

In case of using the urethane oligomer not having a hydrophilic group as in Comparative example 6, the on-press development scum and printing stain are particularly poor. On the other hand, in case of using the urethane oligomer not having a polymerizable group as in Comparative example 7, the printing durability is poor.

TABLE 5: Urethane Oligomer of Variety of A Components (Examples 1 and 24 to 31)

| | Urethane Oligomer | | | | | | | | Polymer particle | Evaluation Result | | |
|---|---|---|---|---|---|---|---|---|---|---|---|---|
| | No. | Kind and Content (% by mol) of Raw Material Component for Synthesis | | | | | | Mw | | Printing Durability (x $10^4$ sheets) | On-Press Printing Development Stain Scum | |
| | | A Component | | B Component | | C Component | | | | | | |
| Example 1 | 1 | A-1 | 40 | B-1 | 35 | C-1 25 | | 3,000 | D1 | 7.0 | 100 | 90 |
| Example 24 | 15 | A-2 | 40 | B-1 | 35 | C-1 | 25 | 3,000 | D1 | 6.5 | 90 | 90 |
| Example 25 | 16 | A-3 | 40 | B-1 | 35 | C-1 | 25 | 3,000 | D1 | 7.0 | 90 | 100 |
| Example 26 | 17 | A-4 | 40 | B-1 | 35 | C-1 | 25 | 3,000 | D1 | 7.0 | 100 | 90 |
| Example 27 | 18 | A-5 | 40 | B-1 | 35 | C-1 | 25 | 3,000 | D1 | 7.0 | 100 | 90 |
| Example 28 | 19 | A-6 | 40 | B-1 | 35 | C-1 | 25 | 3,000 | D1 | 7.0 | 100 | 90 |
| Example 29 | 20 | A-7 | 40 | B-1 | 35 | C-1 | 25 | 3,000 | D1 | 7.0 | 90 | 90 |
| Example 30 | 21 | A-8 | 40 | B-1 | 35 | C-1 | 25 | 3,000 | D1 | 7.0 | 100 | 90 |
| Example 31 | 22 | A-9 | 40 | B-1 | 35 | C-1 | 25 | 3,000 | D1 | 7.0 | 100 | 90 |

From the results shown in Table 5 it can be seen that any of the urethane oligomers containing a variety of A components sufficiently exhibits the effects of the invention.

TABLE 6: Urethane Oligomer of Variety of B Components (Examples 1 and 33 to 41)

| | Urethane Oligomer | | | | | | | | Polymer particle | Evaluation Result | | |
|---|---|---|---|---|---|---|---|---|---|---|---|---|
| | No. | Kind and Content (% by mol) of Raw Material Component for Synthesis | | | | | | Mw | | Printing Durability ($\times 10^4$ sheets) | On-Press Development t Scum | Printing Stain |
| | | A Component | | B Component | | C Component | | | | | | |
| Example 1 | 1 | A-1 | 40 | B-1 | 35 | C-1 | 25 | 3,000 | D1 | 7.0 | 100 | 90 |
| Example 33 | 24 | A-1 | 40 | B-2 | 35 | C-1 | 25 | 3,000 | D1 | 7.0 | 100 | 90 |
| Example 34 | 25 | A-1 | 40 | B-3 | 35 | C-1 | 25 | 3,000 | D1 | 6.5 | 80 | 80 |
| Example 35 | 26 | A-1 | 40 | B-4 | 35 | C-1 | 25 | 3,000 | D1 | 6.5 | 80 | 80 |
| Example 36 | 27 | A-1 | 40 | B-5 | 35 | C-1 | 25 | 3,000 | D1 | 6.5 | 90 | 80 |
| Example 37 | 28 | A-1 | 40 | B-8 | 35 | C-1 | 25 | 3,000 | D1 | 6.5 | 90 | 80 |
| Example 38 | 29 | A-1 | 40 | B-11 | 35 | C-1 | 25 | 3,000 | D1 | 7.0 | 90 | 80 |
| Example 39 | 30 | A-1 | 40 | B-13 | 35 | C-1 | 25 | 3,000 | D1 | 6.5 | 90 | 70 |
| Example 40 | 31 | A-1 | 40 | B-15 | 35 | C-1 | 25 | 3,000 | D1 | 6.5 | 80 | 70 |
| Example 41 | 32 | A-1 | 40 | B-16 | 35 | C-1 | 25 | 3,000 | D1 | 6.5 | 80 | 70 |

From the results shown in Table 6 it can be seen that any of the urethane oligomers containing a variety of B components having a polymerizable group sufficiently exhibits the effects of the invention.

TABLE 7: Urethane Oligomer of Variety of C Components (Examples 1 and 42 to 52)

| | Urethane Oligomer | | | | | | | | Polymer particle | Evaluation Result | | |
|---|---|---|---|---|---|---|---|---|---|---|---|---|
| | No. | Kind and Content (% by mol) of Raw Material Component for Synthesis | | | | | | Mw | | Printing Durability (x $10^4$ sheets) | On-Press Development Scum | Printing Stain |
| | | A Component | | B Component | | C Component | | | | | | |
| Example 1 | 1 | A-1 | 40 | B-1 | 35 | C-1 | 25 | 3,000 | D1 | 7.0 | 100 | 90 |
| Example 42 | 33 | A-1 | 40 | B-1 | 35 | C-3 | 25 | 3,000 | D1 | 7.0 | 100 | 90 |
| Example 43 | 34 | A-6 | 40 | B-3 | 35 | C-5 | 25 | 3,000 | D1 | 7.0 | 100 | 90 |
| Example 44 | 35 | A-1 | 40 | B-1 | 35 | C-6 | 25 | 3,000 | D1 | 6.5 | 80 | 90 |
| Example 45 | 36 | A-1 | 40 | B-1 | 35 | C-9 | 25 | 3,000 | D1 | 7.0 | 100 | 90 |
| Example 46 | 37 | A-1 | 40 | B-1 | 35 | C-11 | 25 | 3,000 | D1 | 7.0 | 100 | 90 |
| Example 47 | 38 | A-1 | 40 | B-1 | 35 | C-12 | 25 | 3,000 | D1 | 6.0 | 100 | 90 |
| Example 48 | 39 | A-1 | 40 | B-1 | 35 | C-14 | 25 | 3,000 | D1 | 7.0 | 100 | 90 |
| Example 49 | 40 | A-1 | 40 | B-1 | 35 | C-16 | 25 | 3,000 | D1 | 7.0 | 90 | 90 |
| Example 50 | 41 | A-1 | 40 | B-1 | 35 | C-18 | 25 | 3,000 | D1 | 7.0 | 100 | 90 |
| Example 51 | 42 | A-1 | 40 | B-1 | 35 | C-20 | 25 | 3,000 | D1 | 6.0 | 90 | 90 |
| Example 52 | 43 | A-1 | 40 | B-1 | 35 | C-21 | 25 | 3,000 | D1 | 6.0 | 90 | 90 |

From the results shown in Table 7 it can be seen that any of the urethane oligomers containing a variety of C components having a hydrophilic group sufficiently exhibits the effects of the invention.

In particular, in the case of using the urethane oligomer containing a polyoxyethylene chain, a betaine structure or an amido group as the hydrophilic group, the better results are obtained. Also, in the case where the number of polyoxyethylene repeating unit included is from 2 to 20, the better results are obtained.

## Claims

1. A lithographic printing plate precursor comprising:

   a support; and
   an image-recording layer an unexposed area of which is capable of being removed with at least one of dampening water and printing ink and contains (a) an infrared absorbing agent, (b) a radical polymerization initiator, (c) a polymer particle and (d) a radical polymerizable urethane oligomer,
   wherein the radical polymerizable urethane oligomer (d) has a polymerizable group and at least one hydrophilic group selected from a sulfo group, a group having a polyoxyalkylene chain, a hydroxy group, an amido group, an ammonium group and a group having a betaine structure and a weight average molecular weight of from 1,500 to 10,000 and is present outside of the polymer particle (c).

2. The lithographic printing plate precursor as claimed in claim 1, wherein the hydrophilic group is a group having a polyoxyalkylene chain, an amido group or a group having a betaine structure.

3. The lithographic printing plate precursor as claimed in claim 2, wherein the hydrophilic group is a group having a polyoxyethylene chain.

4. The lithographic printing plate precursor as claimed in claim 3, wherein a number of oxyethylene repeating unit in the polyoxyethylene chain is from 2 to 20.

5. The lithographic printing plate precursor as claimed in any one of claims 1 to 4, wherein a weight average molecular weight of the radical polymerizable urethane oligomer is from 2,000 to 5,000.

6. The lithographic printing plate precursor as claimed in any one of claims 1 to 5, wherein the radical polymerizable urethane oligomer is a radical polymerizable urethane oligomer obtained by reaction of at least (A) a trifunctional or more functional isocyanate compound, (B) a compound having a methacryloyl group or an acryloyl group and a hydroxy group and (C) a compound having a hydrophilic group and a hydroxy group, and at least one of the compound (B) and the compound (C) has two or more hydroxy groups.

7. The lithographic printing plate precursor as claimed in any one of claims 1 to 6, wherein the polymer particle contains a polyoxyalkylene chain.

8. The lithographic printing plate precursor as claimed in claim 7, wherein the polyoxyalkylene chain contained in the polymer particle is a polyoxyethylene chain.

9. The lithographic printing plate precursor as claimed in claim 8, wherein a number of oxyethylene repeating unit in the polyoxyethylene chain contained in the polymer particle is from 2 to 20.

10. The lithographic printing plate precursor as claimed in any one of claims 1 to 9, wherein the polymer particle is an organic resin particle having as a constituting component, at least acrylonitrile monomer unit.

11. The lithographic printing plate precursor as claimed in any one of claims 1 to 10, wherein the polymer particle contains a monomer unit having one or more ethylenically unsaturated groups.

12. The lithographic printing plate precursor as claimed in any one of claims 1 to 11, which comprises a protective layer so that the support, the image-recording layer and the protective layer are provided in this order.

13. The lithographic printing plate precursor as claimed in claim 12, wherein the protective layer contains a hydrophilic resin.

14. The lithographic printing plate precursor as claimed in claim 12 or 13, wherein the protective layer contains an inorganic stratiform compound.

15. A plate making method of a lithographic printing plate comprising:

exposing imagewise the lithographic printing plate precursor as claimed in any one of claims 1 to 14; and without undergoing a development processing step, supplying at least one of dampening water and printing ink to the exposed lithographic printing plate precursor to remove an unexposed area of the image-recording layer.

## Patentansprüche

1. Lithographiedruckplattenvorläufer, umfassend:

einen Träger; und
eine Bildaufzeichnungsschicht, deren unbelichteter Bereich mit zumindest einem von Anfeuchtwasser und Drucktinte entfernt werden kann und die (a) einen Infrarotabsorber, (b) einen Initiator der radikalischen Polymerisation, (c) einen Polymerpartikel und (d) ein radikalisch polymerisierbares Urethanoligomer enthält,
worin das radikalisch polymerisierbare Urethanoligomer (d) eine polymerisierbare Gruppe und mindestens eine hydrophile Gruppe aufweist, die ausgewählt ist aus einer Sulfogruppe, einer Gruppe mit einer Polyoxyalkylenkette, einer Hydroxygruppe, einer Amidgruppe, einer Ammoniumgruppe und einer Gruppe mit einer Betainstruktur, und das ein gewichtsgemitteltes Molekulargewicht von 1.500 bis 10.000 aufweist und außerhalb des Polymerpartikels (c) vorliegt.

2. Lithographiedruckplattenvorläufer gemäß Anspruch 1, worin die hydrophile Gruppe eine Gruppe mit einer Polyoxyalkylenkette, eine Amidgruppe oder eine Gruppe mit einer Betainstruktur ist.

3. Lithographiedruckplattenvorläufer gemäß Anspruch 2, worin die hydrophile Gruppe eine Gruppe mit einer Polyoxyalkylenkette ist.

4. Lithographiedruckplattenvorläufer gemäß Anspruch 3, worin die Anzahl der Oxyethylen-Wiederholungseinheiten in der Polyoxyethylenkette von 2 bis 20 beträgt.

5. Lithographiedruckplattenvorläufer gemäß irgendeinem der Ansprüche 1 bis 4, worin das gewichtsgemittelte Molekulargewicht des radikalisch polymerisierbaren Urethanoligomers von 2.000 bis 5.000 beträgt.

6. Lithographiedruckplattenvorläufer gemäß irgendeinem der Ansprüche 1 bis 5, worin das radikalisch polymerisierbare Urethanoligomer ein radikalisch polymerisierbares Urethanoligomer ist, das Erhalten ist durch Reaktion von zumindest (A) einer tri- oder höherfunktionellen Isocyanatverbindung, (B) einer Verbindung mit einer Methacryloylgruppe oder einer Acryloylgruppe und einer Hydroxygruppe und (C) einer Verbindung mit einer hydrophilen Gruppe und einer Hydroxygruppe, und worin zumindest eine von der Verbindung (B) und der Verbindung C() zwei oder mehr Hydroxygruppen aufweist.

7. Lithographiedruckplattenvorläufer gemäß irgendeinem der Ansprüche 1 bis 6, worin der Polymerpartikel eine Polyoxyalkylenkette enthält.

8. Lithographiedruckplattenvorläufer gemäß Anspruch 7, worin die Polyoxyalkylenkette, die in dem Polymerpartikel enthalten ist, eine Polyoxyethylenkette ist.

9. Lithographiedruckplattenvorläufer gemäß Anspruch 8, worin die Anzahl der Oxyethylen-Wiederholungseinheiten in der in dem Polymerpartikel enthaltenen Polyoxyethylenkette von 2 bis 20 beträgt.

10. Lithographiedruckplattenvorläufer gemäß irgendeinem der Ansprüche 1 bis 9, worin der Polymerpartikel ein organischer Harzpartikel ist, der als eine Aufbaukomponente zumindest Acrylonitril-Monomereinheiten aufweist.

11. Lithographiedruckplattenvorläufer gemäß irgendeinem der Ansprüche 1 bis 10, worin der Polymerpartikel eine Monomereinheit enthält, die ein oder mehr ethylenisch ungesättigte Gruppen aufweist.

**12.** Lithographiedruckplattenvorläufer gemäß irgendeinem der Ansprüche 1 bis 11, welcher eine Schutzschicht umfasst, so dass der Träger, die Bildaufzeichnungsschicht und die Schutzschicht in dieser Reihenfolge vorgesehen sind.

**13.** Lithographiedruckplattenvorläufer gemäß Anspruch 12, worin die Schutzschicht ein hydrophiles Harz enthält.

**14.** Lithographiedruckplattenvorläufer gemäß Anspruch 12 oder 13, worin die Schutzschicht eine anorganische Schichtverbindung enthält.

**15.** Plattenherstellungsverfahren für eine Lithographiedruckplatte, umfassend:

bildweises Belichten des Lithographiedruckplattenvorläufers gemäß irgendeinem der Anspruche 1 bis 14; und ohne dass er einem Entwicklungsverarbeitungsschritt unterzogen wird, Zuführen von zumindest einem von Anfeuchtwasser und Drucktinte zu dem belichteten Lithographiedruckplattenvorläufer, um einen nichtbelichteten Bereich der Bildaufzeichnungsschicht zu entfernen.

**Revendications**

**1.** Précurseur de plaque d'impression lithographique comprenant :

un support ; et
une couche d'enregistrement d'images dont une zone non exposée peut être éliminée avec au moins l'une ou l'autre d'eau de mouillage et d'encre d'impression et qui contient (a) un agent absorbant les infrarouges, (b) un initiateur de polymérisation radicalaire, (c) une particule de polymère et (d) un oligomère d'uréthane polymérisable par voie radicalaire,
dans lequel l'oligomère d'uréthane polymérisable par voie radicalaire (d) comprend un groupement polymérisable et au moins un groupement hydrophile choisi parmi un groupement sulfo, un groupement comprenant une chaîne polyoxyalkylène, un groupement hydroxy, un groupement amido, un groupement ammonium et un groupement ayant une structure de bétaïne et ayant une masse moléculaire moyenne en poids de 1500 à 10 000 et qui est présent à l'extérieur de la particule de polymère (c).

**2.** Précurseur de plaque d'impression lithographique selon la revendication 1, dans lequel le groupement hydrophile est un groupement comprenant une chaîne de polyoxyalkylène, un groupement amido ou un groupement ayant une structure de bétaïne.

**3.** Précurseur de plaque d'impression lithographique selon la revendication 2, dans lequel le groupement hydrophile est un groupement comprenant une chaîne de polyoxyalkylène.

**4.** Précurseur de plaque d'impression lithographique selon la revendication 3, dans lequel le nombre de motifs récurrents d'oxyéthylène dans la chaîne de polyoxyéthylène est de 2 à 20.

**5.** Précurseur de plaque d'impression lithographique selon l'une quelconque des revendications 1 à 4, dans lequel le poids moléculaire moyen en poids de l'oligomère d'uréthane polymérisable par voie radicalaire est de 2000 à 5000.

**6.** Précurseur de plaque d'impression lithographique selon l'une quelconque des revendications 1 à 5, dans lequel l'oligomère d'uréthane polymérisable par voie radicalaire est un oligomère d'uréthane polymérisable par voie radicalaire obtenu par réaction d'au moins (A) un composé d'isocyanate à trois fonctions ou plus, (B) un composé comprenant un groupement méthacryloyle ou un groupement acryloyle et un groupement hydroxy et (C) un composé comprenant un groupement hydrophile et un groupement hydroxy, et au moins l'un ou l'autre du composé (B) et du composé (C) comprend deux groupements hydroxyle ou plus.

**7.** Précurseur de plaque d'impression lithographique selon l'une quelconque des revendications 1 à 6, dans lequel la particule de polymère contient une chaîne de polyoxyalkylène.

**8.** Précurseur de plaque d'impression lithographique selon la revendication 7, dans lequel la chaîne de polyoxyalkylène contenue dans la particule de polymère est une chaîne de polyoxyéthylène.

**9.** Précurseur de plaque d'impression lithographique selon la revendication 8, dans lequel le nombre de motifs récurrents d'oxyéthylène dans la chaîne de polyoxyéthylène contenue dans la particule de polymère est de 2 à 20.

**10.** Précurseur de plaque d'impression lithographique selon l'une quelconque des revendications 1 à 9, dans lequel la particule de polymère est une particule de résine organique comprenant, en tant que composant constitutif, au moins un motif monomère d'acrylonitrile.

**11.** Précurseur de plaque d'impression lithographique selon l'une quelconque des revendications 1 à 10, dans lequel la particule de polymère contient un motif monomère comprenant un ou plusieurs groupements à insaturation éthylénique.

**12.** Précurseur de plaque d'impression lithographique selon l'une quelconque des revendications 1 à 11, qui comprend une couche protectrice de sorte que le support, la couche d'enregistrement d'images et la couche protectrice soit placés dans cet ordre.

**13.** Précurseur de plaque d'impression lithographique selon la revendication 12, dans lequel la couche protectrice contient une résine hydrophile.

**14.** Précurseur de plaque d'impression lithographique selon la revendication 12 ou 13, dans lequel la couche protectrice contient un composé stratiforme inorganique.

**15.** Procédé de fabrication d'une plaque d'impression lithographique comprenant :

l'exposition selon une image du précurseur de plaque d'impression lithographique selon l'une quelconque des revendications 1 à 14 ; et,
sans effectuer d'étape de traitement de développement, la fourniture d'au moins l'une ou l'autre d' eau de mouillage et d'encre d'impression au précurseur de plaque d'impression lithographique pour éliminer une zone non exposée de la couche d'enregistrement d'images.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001277740 A
- JP 2001277742 A
- JP 2002287334 A
- US 20030064318 A
- JP 2009522609 T
- WO 2007077207 A2
- JP 2001001658 A
- JP 2009226730 A
- JP 2001133969 A
- JP 2002023360 A
- JP 2002040638 A
- JP 2002278057 A
- JP 2008195018 A
- JP 2007090850 A
- JP 5005005 A
- JP 2001222101 A
- JP 8108621 A
- JP 61166544 A
- JP 5158230 A
- US 4069055 A
- JP 4365049 A
- US 4069056 A
- EP 104143 A
- US 20080311520 A
- JP 2150848 A
- EP 370693 A
- EP 233567 A
- EP 297443 A
- US 297442 A
- US 4933377 A
- US 4760013 A
- US 4734444 A
- US 2833827 A
- DE 2904626
- DE 3604580
- DE 3604581
- JP 9123387 A
- JP 9131850 A
- JP 9171249 A
- JP 9171250 A
- EP 931647 A
- US 2800457 A
- US 2800458 A
- GB 990443 A
- US 3287154 A
- JP 3819574 B
- JP 42446 B
- JP 42711 B
- US 3418250 A
- US 3660304 A
- US 3796669 A
- US 3914511 A
- US 4025445 A
- JP 369163 B
- JP 51009079 B
- GB 930422 A
- US 3111407 A
- GB 952807 A
- GB 967074 A
- JP 2005329708 A
- JP 2007276454 A
- JP 2009154525 A
- JP 2006297907 A
- JP 2007050660 A
- JP 2008284858 A
- JP 2009090645 A
- JP 2009208458 A
- JP 2008284817 A
- JP 2006091479 A
- JP 10282679 A
- JP 2304441 A
- JP 2005238816 A
- JP 2005125749 A
- JP 2006239867 A
- JP 2006215263 A
- JP 2006188038 A
- JP 2001253181 A
- JP 2001322365 A
- US 2714066 A
- US 3181461 A
- US 3280734 A
- US 3902734 A
- US 3276868 A
- US 4153461 A
- US 4689272 A
- JP 5045885 A
- US 3458311 A
- JP 55049729 B
- JP 2005250216 A
- JP 2006259137 A
- JP 2005119273 A

## Non-patent literature cited in the description


- **SENRYO BINRAN.** Dye Handbook. The Society of Synthetic Organic Chemistry, 1970
- **S. I. SCHLESINGER.** *Photogr. Sci. Eng.,* 1974, vol. 18, 387
- **T. S. BAL et al.** *Polymer,* 1980, vol. 21, 423
- **J.V. CRIVELLO et al.** *Macromolecules,* 1977, vol. 10 (6), 1307
- **J.V. CRIVELLO et al.** *J. Polymer Sci., Polymer Chem. Ed.,* 1979, vol. 17, 1047
- **C.S. WEN et al.** *Teh, Proc. Conf. Rad. Curing ASIA,* October 1988, 478
- *Research Disclosure,* 1992, (33303